(19) Europäisches Patentamt
European Patent Office
Office européen des brevets

(11) Publication number: **0 066 605**
**B1**

# (12) EUROPEAN PATENT SPECIFICATION

(45) Date of publication of patent specification: **02.11.88**

(51) Int. Cl.$^4$: **G 06 F 13/00,** G 06 F 5/00, H 01 L 27/00

(21) Application number: **82900233.6**

(22) Date of filing: **02.12.81**

(86) International application number: **PCT/US81/01607**

(87) International publication number: **WO 82/02102 24.06.82 Gazette 82/16**

## (54) CHIP TOPOGRAPHY FOR INTEGRATED CIRCUIT COMMUNICATION CONTROLLER.

(30) Priority: **12.12.80 US 215975**

(43) Date of publication of application: **15.12.82 Bulletin 82/50**

(45) Publication of the grant of the patent: **02.11.88 Bulletin 88/44**

(84) Designated Contracting States: **DE FR GB NL**

(56) References cited:
**US-A-3 968 478**
**US-A-3 975 712**
**US-A-4 021 781**
**US-A-4 071 887**
**US-A-4 125 854**
**US-A-4 144 561**
**US-A-4 278 897**
**ELECTRICAL DESIGN NEWS, vol. 23, no. 10, October 1978, pages 109-112, Concord, US; A.J. WEISSBERGER: "Simplify serial data links with LSI chips"**
**Proceedings National Electronic Conference, Vol. 31, 1977, pp. 300-304**

(73) Proprietor: **NCR Corporation**
**World Headquarters**
**Dayton, Ohio 45479 (US)**

(72) Inventor: **KNAPP, George William**
**8 Hillcrest Drive**
**Cambridge, OH 43725 (US)**
Inventor: **SPAULDING, Bernard Browne**
**35 W. First Street**
**The Plains, OH 45780 (US)**

(74) Representative: **Robinson, Robert George**
**International Patent Department NCR Limited**
**206 Marylebone Road**
**London NW1 6LY (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Technical Field

This invention relates to an integrated circuit for connecting a processor to a plurality of remote devices, including output storage means adapted to store data received from said processor, timing signal generating means adapted to selectively generate first and second timing signals, register means adapted to store a control signal received from said processor for selecting one of said first and second timing signals, and control means adapted to control the transmission of data stored in said output storage means in accordance with the selected timing signals, said integrated circuit having first, second, third and fourth sequentially located edges for forming a rectangle.

Background Art

Use of MOS (metal-oxide-semiconductor) large-scale integrated (LSI) circuits in electrical devices has contributed to the cost reduction of such devices. In designing such semiconductor chips, the large number of MOSTs (Metal oxide-semiconductor-transistors) together with the interconnection patterns of conductor lines therebetween must be optimized to provide the highest component density in order to reduce the required chip area to a minimum. Minimum line widths and spacing between the respective conductors composed of either polycrystalline silicon or aluminum and the MOSTs must be maintained to avoid short circuits and parasitic effects. Yet, the length of the interconnecting lines and their associated capacitances must be minimized not only to reduce chip size, but also to achieve maximum circuit operating speeds. A wide variety of trade-offs, including the necessity to minimize chip size, to increase circuit operating speed, to reduce power consumption, and to achieve acceptable reliability are involved in obtaining an optimum "layout" or arrangement of MOSTs and interconnection patterns therebetween in order to obtain a MOS LSI circuit which is both economical and has acceptable operating characteristics. Often, the technical and commercial success of an electronic product utilizing MOS LSI technology hinges on the ability of the chip designer to achieve an optimum chip topography.

Some of the numerous design constraints faced by the MOS LSI chip designer include specifications for the minimum width and spacing of diffused regions in the silicon, the minimum size required for contact openings in the insulating field oxide, the spacings required between the edges of contact openings to the edge of diffused regions, the minimum widths and spacing of polycrystalline silicon conductors, the fact that such polycrystalline silicon conductors cannot coincide with diffused regions, the minimum widths and spacings between the aluminum conductors, and the constraint that conductors on the same layer of insulating oxide cannot cross over like conductors. The high amount of capacitance associated with diffused regions and the resistances of both diffused regions and the polycrystalline silicon conductors must be carefully considered by the circuit designer and the chip designer in arriving at an optimum chip topography.

From Electrical Design News, vol. 23, No. 10, October 1978, pages 109—112, A. J. Weissberger, "Simplify Serial Data Links with LSI Chips", there is known an integrated circuit of the kind specified. The known device ("Signetics 2651") includes six major sections: transmitter, receiver, timing, operation control, modem control and SYN/DLE control, shown as blocks in a functional block diagram. However the physical disposition of such functional blocks and their interconnection paths are not considered.

Proceedings of the National Electronic Conference, vol. 31 (1977), pages 300—304, G. J. Summers, "Microprocessor Controlled LSI in Data Communication Links", also discloses an integrated circuit of the kind specified, and includes a functional block diagram of the Signetics 2651 device. The article includes also a pin configuration diagram and a die photograph of the Signetics 2651 device. However, the identity and disposition of the components shown in the die photograph is not discussed.

Disclosure of the Invention

It is an object of the present invention to provide an integrated circuit communication controller chip for effecting the transfer of data signals between a plurality of remote peripheral devices and a processor in which the integrated circuit chip has a topography which provides a high circuit operating speed with low chip size and power dissipation.

Therefore, according to the present invention, there is provided an integrated circuit of the kind specified, characterized in that said output storage means includes first and second output storage sections each located closer to said third edge than to said first edge, in that address decode means is provided located adjacent the corner between said first and fourth edges, in that said timing signal generating means is located closer to said first edge than to said third edge, in that said control means is located substantially closer to said first edge than to said third edge, in that said register means is located closer to said second edge than to said fourth edge, in that address bus means is provided coupled to said address decode means and to said first and second output storage sections, said address bus means being located adjacent said first, second and fourth edges and extending substantially through the middle of said integrated circuit parallel to said first and third edges, in that timing bus means is provided, coupled to said timing signal generating means and to said control means and located adjacent first edge and in that mode bus means is provided, coupled to said register means and to said control means and extending substantially through the middle of said integrated circuit parallel to said first and third edges.

It has been found that the placement of the various circuits in accordance with the present invention minimizes the length of interconnection conductors, thereby reducing their associated capacitances and resistances.

An advantage of an integrated circuit chip according to the invention is the capability of generating more than one data format for transmission between a processor and a plurality of remote devices at more than one clock rate.

A further advantage is that the circuit elements are arranged on the integrated circuit chip to minimize the length of the interconnecting conductors resulting in the cost of the chip being very low.

It will be appreciated that the described embodiment of the invention provides an MOS LSI communication controller integrated chip having optimized chip topography. The chip topography includes two full duplex communication channels and internal data, address, mode, timing and control buses. The integrated circuit chip includes left, top, right and bottom sequentially located edges for forming a rectangle. Input/output circuitry for each communication channel is located along the right edge of the chip and is coupled to the address, data and control buses. Clock control circuits located along the left edge of the chip provide either one of two data clocking frequencies. A clock generator circuit is located in the upper left hand corner of the chip which, together with the input/output circuitry, receives control signals from the processor for generating a plurality of clock signals for use in operating the circuitry. The integrated circuit chip includes storage circuits located along the right edge of the chip in which input and output data is stored under the control of the input/output circuitry. The input/output circuitry and the storage circuits are spaced apart, allowing the buses to be located adjacent circuits to which the buses are connected. Counter circuits coupled to the clock generator circuit provide selected first and second clock rates used in transmitting data between the processor and the peripheral devices.

Brief Description of the Drawings

One embodiment of the invention will now be described by way of example with reference to the accompanying drawings, in which:

Figs. 1A and 1B, taken together, constitute a block diagram of a communication controller system in which the integrated circuit of the present invention is included;

Fig. 2 is a block diagram illustrating the general location of the major sections of circuitry on the surface of the integrated circuit chip of the present invention;

Figs. 3A—3F inclusive, taken together, provide a more detailed block diagram of Fig. 2 illustrating the general location of the various sections of circuitry on the surface of the integrated circuit chip of the present invention;

Fig. 4 is a diagram showing how Figs. 3A—3F inclusive are arranged;

Fig. 5 is a scale reproduction of a photo mask utilized to define the pattern of the source-drain diffused regions in the integrated circuit chip of the present invention;

Fig. 6 is a scale reproduction of a photo mask utilized to define the pattern of the ion implanted depletion regions of the integrated circuit chip of the present invention;

Fig. 7 is a scale reproduction of a photo mask utilized to define the pattern of contacts between the polycrystalline silicon conductors and the diffused regions of the integrated circuit chip of the present invention;

Fig. 8 is a scale reproduction of a photo mask utilized to define the pattern of the polycrystalline silicon layer of the integrated circuit chip of the present invention;

Fig. 9 is a scale reproduction of a photo mask utilized to define all conductor interconnection contacts in the integrated circuit chip of the present invention;

Fig. 10 is a scale reproduction of a photo mask utilized to define the pattern for the metal interconnection layer of the integrated circuit chip of the present invention showing locations of the mounting pads together with the signals associated with the circuit;

Fig. 11 is a scale reproduction of a photo mask utilized to defined the pattern of the passivation layer of the integrated circuit chip of the present invention;

Fig. 12 is a scale reproduction of a composite of all the photo masks used in the fabrication of the integrated circuit chip of the present invention; and

Fig. 13 is a diagram illustrating the package and lead configuration of the package in which the integrated circuit of the present invention is ultimately housed.

Best Mode for Carrying Out the Invention

Referring now to Figs. 1A and 1B, there is shown a block diagram of the communication controller circuit generally indicated by the numeral 18 which includes an interface logic unit 20 which interfaces a host processor (CPU) 21 with a plurality of remote peripheral devices (not shown) over a pair of communication channels each consisting of four wires 22—28 inclusive. Since each channel is of the same construction, the following description will cover only one channel with like elements in both channels having the same numerical designation.

As shown in Fig. 1, each channel includes an Output Buffer 30 in which a data character transmitted in parallel over the data bus 32 from the host processor 21 is stored. Under control of signals generated in a Control Logic unit 36, the data character stored in the Output Buffer 30 is transferred in parallel over bus 38 to the Serial Send Register 40 along with the required parity bits. The data character is shifted synchronously with the clock signals CLK0 on line 24 out of the and spacings of the polycrystalline silicon lines, the fact that such lines cannot cross over diffused regions and the minimum width and spacings between the metal lines, and of course the constraint that conductors in the same layer, that is, diffused regions, polycrystalline silicon lines or metallization lines cannot cross other of the same type conductors. The high amount of capacitance associated with diffused regions and the resistance of both diffused lines and polycrystalline silicon lines and to a less extent of metal lines provide further design constraints upon the chip architect. For logic circuits which may be characterized as random logic, such as those in the subject invention, a large number of lines between sections of logic circuitry are required and the very large number of possibilities for routing the various kinds of conductors to the various required sections of the chip taxes the ingenuity of even the most competent chip topology architect, and further taxes the capacity of the most sophisticated computer interconnection conductor routing programs yet available.

It should be noted that those skilled in the art can prepare a mask set for manufacturing the integrated chip on the basis of the scale reproductions of the photo mask disclosed in Figs. 5—12 inclusive.

In a 28-pin dual-in-line semiconductor package suitable for housing the communication controller interface chip 15 described herein is illustrated in Fig. 13. The sequence of the pins is chosen to provide maximum utility in placing such a chip on a printed circuit board.

**Claims**

1. An integrated circuit for connecting a processor to a plurality of remote devices, including output storage means (30, 100, 40; 30, 104, 40) adapted to store data received from said processor, timing signal generating means (86) adapted to selectively generate first and second timing signals, register means (70) adapted to store a control signal received from said processor for selecting one of said first and second timing signals, and control means (88, 90, 92, 94) adapted to control the transmission of data stored in said output storage means (30, 100, 40; 30, 104, 40) in accordance with the selected timing signals, said integrated circuit having first (78), second (74), third (80) and fourth (76) sequentially located edges for forming a rectangle, characterized in that said output storage means includes first and second output storage sections (30, 100, 40; 30, 104, 40) each located closer to said third edge (80) than to said first edge (78), in that address decode means (96) is provided located adjacent the corner between said first and fourth edges (78, 76), in that said timing signal generating means (86) is located closer to said first edge (78) than to said third edge (80), in that said control means (88, 90, 92, 94) is located substantially closer to said first edge (78) than to said third edge (80), in that said register means (70) is located closer to said second edge (74) than to said fourth edge (76), in that address bus means (106) is provided coupled to said address decode means (96) and to said first and second output storage sections (30, 100, 40; 30, 104, 40), said address bus means (106) being located adjacent said first, second and fourth edges and extending substantially through the middle of said integrated circuit parallel to said first and third edges, in that timing bus means (124) is provided, coupled to said timing signal generating means (86) and to said control means (88, 90, 92, 94) and located adjacent said first edge (78), and in that mode bus means (110) is provided, coupled to said register means (70) and to said control means (88, 90, 92, 94) and extending substantially through the middle of said integrated circuit parallel to said first and third edges (78, 80).

2. An integrated circuit according to claim 1, characterized by a plurality of bonding pads located adjacent said third edge (80), said bonding pads being coupled to said output storage means (30, 100, 40; 30, 104, 40).

3. An integrated circuit according to claim 2, characterized in that said timing signal generating means (86) includes a counter (114) coupled to a decoder (116) which is coupled to a frequency selector (118) adapted to provide the desired one of said first and second timing signals in accordance with the control signals stored in said register means (70).

4. An integrated circuit according to claim 3, characterized in that said control means includes a send control circuit (148) responsive to a send control signal provided by said processor to enable a clock generator circuit (150) to provide output clock signals for application to said remote devices, thereby enabling the data bits stored in said output storage means (30, 100, 40) to be transmitted to a remote device.

5. An integrated circuit according to claim 4, characterized in that said register means (70) is adapted to store a further control signal received from said processor for selecting the number of data bits to be transmitted to said remote devices, said control means including a further counter (154) coupled to said clock generator circuit (150) and to a counter decoder circuit (156) coupled to said register means (70) and adapted to limit the number of said output clock signals in accordance with said further control signal.

6. An integrated circuit according to claim 5, characterized by decoder means (96) adapted to be coupled to said processor and to provide said control signal and said further control signal and to control the addressing of said remote devices, said decoder means (96) being located adjacent the corner between said first (78) and fourth (76) edges.

7. An integrated circuit according to claim 6, characterized in that each output storage section includes an output buffer (30) adapted to receive a data character provided in parallel by said processor and a serial shift register (40) coupled to Serial Send Register 40 and transmitted by a Data Driver 42 over the send data (SDATA) line 22 to the selected remote peripheral device at one of two clock rates selected by the Control Logic unit 36. At the completion of the transmission of the data character and its associated parity bits in a manner that will be described more fully hereinafter, the Control Logic unit 36 will signal the Bus Interface Logic unit 20 over line 43 enabling the unit 20 to lower the signal $\overline{INT}$ over line 56 raising an interrupt to the processor 21. The selected clock out signals CLKO are outputted by a Clock Driver 44 over line 24 to a remote peripheral device.

When a remote peripheral device requests access to the host processor 21, the peripheral device will lower the signal on the receive data ($\overline{RDATA}$) line 28 signalling the Control Logic unit 36 of the request. The Control Logic unit 36 will enable a Clock Driver 46 to output one of two clock in signals (CLKI) over line 26 enabling the peripheral device to transfer the data character over line 28 through a Data Receiver 48 and into the Serial Receive Register 50. Under the control of signals generated by the Control Logic unit 36, the data character in the Serial Receive Register 50 is loaded in parallel over bus 52 into an Input Buffer 54. At this time, the Control Logic unit 36 will signal the Bus Interface Logic unit 20 of the storing of the data character in the Buffer 54, enabling the Bus Interface Logic unit 20 to lower the signal $\overline{INT}$ on line 56 raising an interrupt to the processor 21.

The communication format of the serial data message is provided by the processor over the data bus 32 on lines 58—68 inclusive. The Bus Interface Logic unit 20 will load the Mode Register 70 with a data word signifying that the data format generated will be either an 8-bit word or a 9-bit word, together with one of two clock rates. In an 8-bit word data format, five bits represent the data to be transferred, one bit is an end-of-message flag, while two bits are used for parity checking. In the 9-bit format, eight bits represent the data while one bit represents the "end-of-message" flag. Each of the data formats can be executed at a clock rate of either 48 KHz. or 144 KHz. In addition to the Mode Register 70, the controller 18 includes a Status Register 72 which includes data indicating a character is required to be written to the Ouput Buffer 30; a character is available to be read from the Input Buffer 54; a parity error was detected during the reception of the 8-bit data character format and a last byte flag was detected during reception. Also included in the controller circuit 18 is a Control Register 75 which provides task definition. Data stored in the Register 75 provides masking of the signal $\overline{INT}$, transmitting of the last character and diagnostic selection.

Referring now to Fig. 2, there is shown a block diagram illustrating the general location of the major sections of the circuitry on the surface of the integrated circuit chip of the present invention herein generally designed by the numeral 15. The chip includes top 74, bottom 76, left 78 and right side edges 80. The edge assignments are used in explaining the topography of the chip with the realization that a chip may have an orientation other than that shown in the drawing. Located adjacent the left portion of the top edge 74 is a biphase Clock Generator 82 for generating the various clock signals used by the controller. Located in the upper central portion of the chip in a horizontal alignment and located closer to the top edge 74 than to the bottom edge 76 are the Control Register 75, an Interrupt Control circuit 84 which is located in the Control Logic unit 36 (Fig. 1), the Mode Register 70 and the Status Register 72. Stacked along the left edge 78 and closer thereto than to the right edge 80 of the chip is a Sync Counter 86 for selecting the clock rates at which the data is to be transmitted, a Receive Handshake circuit 88 for enabling data to be shifted into the Serial Receiver Register 50 from the peripheral device, and a Send Handshake circuit 90 for enabling data received from the host processor 21 (Fig. 1) to be transmitted through the Serial Send Register 40 to the peripheral devices. The circuits 86—90 inclusive are located in the Control Logic unit 36 associated with channel 1 of the controller 18.

Further included in the stack is a Receive Handshake circuit 92 and a Send Handshake circuit 94 constructed for operation in the same manner as circuits 88 and 90. Circuits 92 and 94 are located in the Control Logic unit 36 (Fig. 1) associated with channel 2. Located adjacent the corner between the left edge 78 and the bottom edge 76 of the chip is an Address Decode circuit 96 located in the Bus Interface Logic unit 20 (Fig. 1) which decodes the address bits transmitted over the A0 line 60, A1 line 62 from the processor 21 and the read/write strobes $\overline{RD}$ appearing on line 64 and $\overline{WR}$ on line 66 for use in addressing the peripheral devices for which the data is intended.

Stacked vertically along the right edge 80 of the chip and closer thereto than to the left edge 78 is the Input Buffer unit 54, a Parity Check circuit 98 for checking the parity bit of the data received from the peripheral device, the Serial Receive Register 50, a Parity Generator circuit 100 for generating a parity bit for the data outputted to the peripheral device and the Output Buffer 30. The latter-cited circuit elements are associated with channel 1 of the controller circuit 18 with the Parity Check circuit 98 and the Parity Generator circuit 100 located in the Control Logic unit 36 (Fig. 1).

Further located in the stack along the right edge 80 of the chip are similar circuit elements associated with channel 2 of the controller circuit 18. These elements include the Input Buffer unit 54, Parity Check circuit 102, Serial Receive Register 50, Serial Send Register 40, Parity Generator circuit 104 and the Output Buffer unit 30 with circuits 102 and 104 located in the Control Logic unit 36 (Fig. 1) associated with channel 2 of the controller circuit.

Referring now to Figs. 3A—3F inclusive and as arranged in the manner disclosed in Fig. 4, there is shown a more detailed block diagram of the circuits location disclosed in Fig. 2. Included in the circuitry is an address bus 106 (Figs. 3A—3F inclusive) extending along the top edge 74 of the chip between the Clock Generator circuit 82 (Fig. 2) and the Register circuits 70—75 inclusive. The address bus 106 also extends along the left 78 and bottom sides 76 of the chip and further extends vertically through the middle of the chip (Figs. 3B, 3D and 3F). The address bus 106 distributes the decoded address signals from the Address Decode circuit 96 (Fig. 3E) which receives over lines 58—66 inclusive (Fig. 1) the address signals from the processor 21. The circuit decodes the signal and transmits the decoded signals over the bus 106 to the Control Register 75 for writing a control byte of data signalling the last byte of a message being sent to the peripheral device; the Mode Register 70 for selecting the clock rate used to transmit/receive the data and word format; the Receive and Send Handshake circuits 88—94 inclusive and to the Input and Output Buffers 54 and 30 respectively enabling a data message to be transferred between the host processor 21 and a remote peripheral device in a manner that will be described more fully hereinafter.

Further included in the circuitry is a control bus 108 extending through the middle of the chip and over which control signals stored in the Control Register 75 (Fig. 3A) are distributed to other circuits on this chip for controlling the operation of the controller circuit 18. Located between the control bus 108 and a portion of the address bus 106 is a mode bus 110, and the data bus 32 (112 in Figs. 3B, 3D and 3F). The mode bus is coupled to the Mode Register 70 (Fig. 3B) which stores data bits selecting the clock rate and word format by which data is transmitted between the communications controller circuit 18 and the remote peripheral devices. In the case of a data character transmission, the data character is transferred over the data bus 32 (Figs. 1, and 3F) from the processor 21 to the Output Buffer 30 (Fig. 3F). The data character is transferred through the Parity Generator 104, which appends the appropriate parity information to the Serial Send Register 40 for serial transmission to the peripheral device. In the case of a data character originating in the peripheral device, the data character described previously is received in the Serial Receive Register 50 (Fig. 3B) from which it passes through the Parity Check circuit 102 (Fig. 3D) and transferred to the Input Buffer 54 from where it is transferred on the data bus 32 (112 in Fig. 3F) to the processor 21.

Referring now to Fig. 3A, there is shown a diagram of the Sync Counter 86 which includes a 4-bit Sync Counter 114 receiving 1.152 MHz. clock signals over line 115 (Fig. 1) from the processor 21. The Counter 114 is controlled by signals CLK1 and CLK2 received over line 120 and 122 respectively from the Mode Register 70 (Fig. 3B) and distributed through the mode bus 110 for selecting the clock rate of 48 KHz. or 144 KHz. respectively. The output bits of the Counter 114 are decoded in Counter Decoder 116 and transmitted to the Frequency Selector 118 which selects the required clock frequency in accordance with the mode signals CLK1 and CLK2 for distribution through a timing bus 124 which extends along the left edge of the chip adjacent the address bus 106.

Located between the Sync Counter 86 on the chip is the Receive Handshake circuit 88 associated with channel 1 of the controller circuit 18 for controlling the storing of the data received from the peripheral device in the Serial Receive Register 50. Since the construction and operation of the Receive Handshake circuit 88 for channel 1 is the same for the Receive Handshake circuit 88 (Fig. 3C) for channel 2, the description of the circuit will be limited to the circuits shown in Fig. 3A, and like numerals will be used in both circuits to designate like elements.

Included in the Receive Handshake circuit 88 (Fig. 3A) is the CLOCK I Generator 126 which receives over timing bus 124 the 48 KHz. or the 144 KHz. clock signals generated by the Sync Counter 86 in the manner described previously. When the RDATA 1 line 28 (Fig. 1) goes low indicating that the peripheral device is ready to send data to the processor, a Receive Control unit 130 comprising a pair of flip-flops enable the CLOCK I Generator 126 to output the clock signals received over bus 128. The output clock signal (CLOCK I) corresponding to either 48 or 144 KHz. is outputted over line 26 (Figs. 1, 3A and 3B) to the peripheral device, enabling the peripheral device to clock out a data character into the Serial Receive Register 50 (Fig. 3B) over line 28. The Register 50 is controlled by shift in signals SFTI generated by the CLOCK I Generator 126 over line 134. The contents of the Register 50 are transferred by a load signal transmitted over the control bus 108 from the Control Register 75 to the Input Buffer 54.

The CLOCK I output signals from the Generator 126 are also transmitted over line 26 to a Counter 136 which counts the number of CLOCK I transitions outputted by the Generator 126. As previously described, data stored in the Mode Register 70 (Fig. 3B) selects an 8-bit data format (S) for processing or a 9-bit format (F) in which the latter format does not include a parity bit. In accordance with the level of the format data signal S/FI appearing on input line 138 (Fig. 3A and 3B) from the mode bus 110, a Counter Decoder 140 (Fig. 3A) coupled to the output of the CLOCK I Counter 136 will output a stop receive signal over line 142 of the Counter 136 if the Counter has reached a count equal to the selected format, thus indicating that the data character received from the peripheral device is stored in the Receive Register 50 (Fig. 3). The stop receive signal appearing on line 142 will stop the operation of the Handshake circuit 88.

After a predetermined time period which allows the received data character to pass through the Parity Check circuit 98 if required, the Receive Control circuit 130 will output the signal LD INPUT BUF over line 144 to the Input Buffer 54 (Fig. 3B) through the control bus 108 allowing the received data character stored in the Receive Register 50 to be transferred into the Input Buffer 54. Once the data character has been loaded into the Input Buffer 54, the Interrupt Control unit 84 (Fig. 3A) in response to the generation of the LD INPUT BUF signal will generate the interrupt signal $\overline{INT}$ over line 56 (Figs. 1, 3A and 3B) notifying the host processor 21 of the available data character if the Control Register input enable bit is set. The Receive Control circuit 130 upon generating the signal LD INPUT BUF disables the Receive Handshake circuit 88 from loading the Input Buffer 50 with a received data character until the data character presently in the Input Buffer 54 is read by the processor 21.

When the processor 21 has a data character for transmission to a peripheral device, the address signals $\overline{CS}$, A0, A1, $\overline{RD}$, $\overline{WR}$ appearing on lines 58—66 inclusive (Figs. 1 and 3E) will be decoded by the Address Decoder circuit 96 resulting in the decoded write output buffer signal WR OUT BUF appearing on the address bus 106. The data signals D0—D7 appearing on bus 32 (Fig. 1) will be transmitted to the Output Buffer 30 (Fig. 3D) over the data bus 112 in response to the WR OUT BUF signal appearing on line 133 (Fig. 3D). The write output buffer signal WR OUT BUF is also transmitted over the address bus 106 and over line 146 to a Send Control circuit 148 of the Send Handshake circuit 90 (Fig. 3C) which enables a Clock Generator 150 to output the data clock signal CLKO over line 24 (Figs. 1, 3C and 3D) to the peripheral device receiving the data. The Send Control circuit 148 will also output the load signal LD SSR 1 over line 160 to the Serial Send Register 40 (Fig. 3D) through the control bus 108 to transfer the data character from the Output Buffer 30 to the Serial Send Register 40. The CLK0 Generator 150 receives over bus 152 the clock signal outputted from the Sync Counter 86 (Fig. 3A) corresponding to either 48 or 144 KHz. as was explained previously with respect to the operation of the Receive Handshake circuitry 88.

Operating in the same manner as the Receive Handshake circuit 88, a CLOCK 0 Counter 154 in the Send Handshake circuit will count the clock signals outputted by the Generator 150, which count is transmitted to a Counter Decoder 156 which in turn decodes the output count in accordance with the signal S/F appearing on line 138, thereby selecting the data format in the manner explained previously. The Decoder 156 will output the signal STOP SEND over line 158 upon completion of the transmission of the data character from the Send Register 40 (Fig. 3D) in accordance with the selected data format thereby disabling the signal LD SSR 1. The data character is shifted out of the Send Register 40 and over line 22 by the Data Driver 42 (Fig. 1B) synchronously with signal CLK0 on line 24 to the peripheral device.

If the data format selected by the signal S/F indicates parity bits, the Parity Generator 100 (Fig. 3D) is operated by the signal to add the required parity bits to the data character transmitted from the Output Buffer 30 to the Send Register 40.

Once a data character has been transferred from the Output Buffer 30, a new character can be transferred into the Output Buffer 30 while the previous character is stored in the Send Register 40. The stop send signal appearing on line 158 (Fig. 3C) in the Send Handshake indicates the completion of the serial transfer of the data character and allows another character to be transferred to the Serial Send Register 40. This construction allows the processor 21 to do a double write operation, thereby increasing the performance of a write operation.

Referring now to Fig. 10, there is shown the location of the bonding pads for the input and output signals through the controller chip 15. The 1.152 MHz. clock signal CLK bonding pad was placed in the top edge 74 of the chip 15 adjacent the Clock Generator circuit 82 (Fig. 2). The bonding pads for the signals $\overline{RST}$, $\overline{RD}$, $\overline{CS}$, $\overline{WR}$, A1, A0 and D0—D3 inclusive generated by the processor 21 are located along the left portion of the top and bottom edges of the chip, together with the left edge of the chip to conveniently connect the host processor 21 to the controller chip 15. The bonding pads for the data signals D4—D7 and the interrupt signal $\overline{INT}$ transmitted between the processor 21 and the controller chip 15 are located adjacent the upper right hand corner adjacent the Interrupt Control 84 and Mode Register 70 (Fig. 2) which receive such signals. The bonding pad for the data and clock signals RDATA, SDATA, CLK0 AND CLK1 associated with each communication channel are located on the right edge 80 and the right portion of the bottom edge 76 of the controller chip adjacent the Registers and Buffers associated with each channel. The double bonding pads for the voltages supplied in $V_{DD}$ located in the top edge 74 and $V_{SS}$ located in the bottom edge 76 of the chip optimizes power bus routing and substrate grounding.

It has been found that the placement of the various circuits shown in Fig. 2 minimizes the length of the interconnected conductors, thereby reducing their associated capacitances and resistance. Numerous capacitance and resistance calculations and modifications of the topography of the circuitry were made to achieve optimum performance in data transmission between the processor and the peripheral devices.

It should be recognized that a very high level of creativity is required of the architect in designing MOS LSI random logic chips such as are used in microcomputers or microprocessor chips and the like because of the layout constraints for state-of-the-art manufacture processes. For example, for silicon gate MOS manufacturing processes, the major constraints are the minimum widths and spacings of the diffused regions, the minimum widths and spacings for depletion mode gate implants, the minimum size required for pre-ohmic openings in the field oxide, the spacings required for the edge of pre-ohmic openings to the edge of diffused regions, the minimum widths said output buffer (30) and adapted to receive in parallel said data character from said output buffer (30) and to shift the data character out for transmission to a remote device in synchronism with said clock signals.

8. An integrated circuit according to claim 1, characterized by input storage means (50, 98, 54; 50, 102, 54) adapted to store data received from a remote device, said input storage means (50, 98, 54; 50, 102, 54) being located substantially closer to said third edge (80) than to said first edge (78), and including first and second input storage sections (50, 98, 54; 50, 102, 54) coupled to said address bus means (106).

**Patentansprüche**

1. Integrierte Schaltung zum Verbindun eines Prozessors mit einer Vielzahl von entfernten Vorrichtungen, mit Ausgangs-Speichervorrichtungen (30, 100, 40; 30, 104, 40), die geeignet sind, von dem Prozessor empfangene Daten zu speichern, einer Zeitgabesignal-Erzeugungsvorrichtung (86), die geeignet ist, selektiv erste und zweite Zeitgabesignale zu erzeugen, eine Registervorrichtung (70), die geeignet ist, ein von dem genannten Prozessor empfangenes Steuersignal zum Auswählen eins der genannten ersten und zweiten Zeitgabesignal zu speichern, und Steuervorrichtungen (88, 90, 92, 94), die geeignet sind, die Übertragung von in den genannten Ausgangs-Speichervorrichtungen (30, 100, 40; 30, 104, 40) gespeicherten Daten in Einklang mit den ausgewählten Zeitgabesignalen zu steuern, wobei die integrierte Schaltung eine erste (78), zweite (74), dritte (80) und vierte (76) aufeinanderfolgend angeordnete Kante zum Bilden eines Rechtecks aufweist, dadurch gekennzeichnet, daß die genannten Ausgangs-Speichervorrichtungen (30, 100, 40; 30, 104, 40) jeweils wesentlich näher an der genannten dritten Kante (80) als an der genannten ersten Kante (78) angeordnet sind, daß eine Adressendekodiervorrichtung (96) benachbart zur Ecke zwischen der ersten und vierten Kante (78, 76) angeordnet ist, daß die Zeitgabesignal-Erzeugungsvorrichtung (86) näher an der genannten ersten Kante (78) als an der genannten dritten Kante (80) angeordnet ist, daß die genannte Steuervorrichtung (88, 90, 92, 94) wesentlich näher an der genannten ersten Kante (78) als an der genannten dritten Kante (80) angeordnet sind, daß die genannte Registervorrichtung (70) näher an der genannten zweiten Kante (74) als an der genannten vierten Kante (76) angeordnet ist, daß eine Adressensammelleitungsvorrichtung (106) gekoppelt mit der genannten Adressendekodiervorrichtung (96) und mit den genannten ersten und zweiten Ausgangs-Speicherabschnitten (30, 100, 40; 30, 104, 40) angeordnet ist, wobei die Adressensammelleitungsvorrichtung (106) benachbart zu der genannten ersten, zweiten und vierten Kante angeordnet ist und sich im wesentlichen durch die Mitte der genannten integrierten Schaltung parallel zu der genannten ersten und dritten Kante erstreckt, daß eine Zeitgabesammelleitungs-Vorrichtung (124) vorgesehen ist, die mit der genannten Zeitgabesignal-Erzeugungsvorrichtung (86) und den genannten Steuervorrichtungen (88, 90, 92, 94) gekoppelt und benachbart zur genannten ersten Kante (78) angeordnet ist, und daß eine Betriebsartsammelleitungsvorrichtung (110) vorgesehen ist, die mit der genannten Registervorrichtung (70) und mit den genannten Steuervorrichtungen (88, 90, 92, 94) gekoppelt ist und sich im wesentlichen durch die Mitte der genannten integrierten Schaltung parallel zu der genannten ersten und dritten Ecke (78, 80) erstreckt.

2. Integrierte Schaltung nach Anspruch 1, dadurch gekennzeichnet, daß eine Vielzahl von Verbindungsanschlüssen benachbart der genannten dritten Kante (80) angeordnet ist, wobei die genannten Verbindungsanschlüsse gekoppelt sind mit den genannten Ausgangsspeichervorrichtungen (30, 100, 40; 30, 104, 40).

3. Integrierte Schaltung nach Anspruch 2, dadurch gekennzeichnet, daß die genannte Zeitgabesignal-Erzeugungsvorrichtung (86) einen Zähler (114) aufweist, der mit einem Decodierer (116) gekoppelt ist, der mit einem Frequenzselektor (118) gekoppelt ist, der geeignet ist, das gewünschte der genannten ersten und zweiten Zeitgabesignale gemäß den in der genannten Registervorrichtung (70) gespeicherten Steuersignalen abzugeben.

4. Integrierte Schaltung nach Anspruch 4, dadurch gekennzeichnet, daß die genannte Steurvorrichtung eine Sendesteuerschaltung (148) aufweist, die auf ein vom genannten Prozessor abgegebenes Sendesteuersignal anspricht, um eine Taktgeneratorschaltung (150) zu befähigen, Ausgangstaktsignale zum Anlegen an die genannten entfernten Vorrichtungen abzugeben, wodurch ermöglicht wird, daß die in den genannten Ausgangsspichervorrichtungen (30, 100, 40) gespeicherten Datenbits zu einer entfernten Vorrichtung übertragen werden.

5. Integrierte Schaltung nach Anspruch 4, dadurch gekennzeichnet, daß die genannte Registervorrichtung (70) geeignet ist, ein weiteres von dem genannten Prozessor empfangenes Steuersignal zum Wählen der Anzahl von zu den genannten entfernten Vorrichtungen zu übertragenden Datenbits zu speichern, wobei die genannte Steuervorrichtung einen weitern Zähler (154) aufweist, der mit der genannten Taktgeneratorschaltung (150) und mit einer Zähler-Decodiererschaltung (156) gekoppelt ist, die mit der genannten Registervorrichtung (70) gekoppelt und geeignet ist, die Anzahl der genannten Ausgangstaktsignale gemäß dem genannten weiteren Steuersignal zu begrenzen.

6. Integrierte Schaltung nach Anspruch 5, gekennzeichnet durch eine Decodiervorrichtung (96), die geeignet ist mit dem genannten Prozessor gekoppelt zu werden und das genannte Steuersignal und das genannte weitere Steuersignal abzugeben und die Adressierung der genannten entfernten Vorrichtungen zu steuern, wobei die genannte Decodierervorrichtung (96) benachbart zur Ecke zwischen der genannten ersten (78) und vierten (76) Kante angeordnet ist.

7. Integrierte Schaltung nach Anspruch 6, dadurch gekennzeichnet, daß jeder Ausgangspeicherabschnitt einen Ausgangspuffer (30) aufweist, der geeignet ist ein Datenzeichen zum empfangen, das parallel von dem genannten Prozessor abgegeben wird, sowie ein serielles Schieberegister (40), das mit dem gennanten Ausgangspuffer (30) gekoppelt und geeignet ist, parallel das gennante Datenzeichen von dem genannten Ausgangspuffer (30) zum empfangen und das Datenzeichen zur Übertragung zu einer entfernten Vorrichtung synchron mit den genannten Taktsignalen auszuschieben.

8. Integrierte Schaltung nach Anspruch 1, gekennzeichnet durch Eingangs-Speichervorrichtungen (50, 98, 54; 50, 102, 54), die geeignet sind, von einer entfernten Vorrichtung empfangene Daten zu speichern, wobei die genannten Eingangs-Speichervorrichtungen (50, 98, 54; 50, 102, 54) wesentlich näher an der genannten dritten Kante (80) als an der genannten ersten Kante (78) angeordnet sind, und die erste und zweite mit der Adressensammelleitungsvorrichtung (106) gekoppelt Eingangs-Speicherabschnitte (50, 98, 54; 50, 102, 54) aufweisen.

**Revendications**

1. Circuit intégré pour connecter un processeur à plusieurs dispositifs éloignés, comprenant des moyens de mémorisation de sortie (30, 100, 40; 30, 104, 40) conçus pour mémoriser des données reçues dudit processeur, des moyens (86) de génération de signaux de synchronisation conçus pour générer sélectivement des premier et second signaux de synchronisation, des moyens à registre (70) conçus pour mémoriser un signal de command reçu dudit processeur pour sélectionner l'un desdits premier et second signaux de synchronisation, et des moyens de commande (88, 90, 92, 94) conçus pour commander la transmission de données mémorisées dans lesdits moyen de mémorisation de sortie (30, 100, 40; 30, 104, 40) conformément aux signaux de synchronisation sélectionnés, ledit circuit intégré ayant des premier (78), deuxième (74), troisième (80) et quatrième (76) bords disposés séquentiellement pour former un rectangle, caractérisé en ce que lesdits moyens de mémorisation de sortie comprennant des première et deuxième parties de mémorisation de sortie (30, 100, 40; 30, 104, 40) situées chacune plus près dudit troisième bord (80) que dudit premier bord (78), en ce que des moyens (96) de décodage d'adresse sont prévus et disposés à proximité immédiate de l'angle entre lesdits premier et quatrième bords (78, 76), en ce que lesdits moyens (86) de génération de signaux de synchronisation sont disposés plus près dudit premier bord (78) que dudit troisième bord (80), en ce que lesdits moyens de commande (88, 90, 92, 94) sont disposés sensiblement plus près dudit premier bord (78) que dudit troisième bord (80), en ce que lesdits moyens à registre (70) sont disposés plus près dudit deuxième bord (74) que dudit quatrième bord (76), en ce que des moyens à bus d'adresse (106) sont prévus et couplés auxdits moyens (96) de décodage d'adresse et auxdites première et seconde parties de mémorisation de sortie (30, 100, 40; 30, 104, 40), lesdits moyens à bus d'adresse (106) étant disposés à proximité immédiate desdits premier, deuxième et quatrième bords et s'étendant sensiblement à travers le milieu dudit circuit intégré, parallèlement auxdits premier et troisième bords, et ce que des moyens (124) à bus de synchronisation sont prévus, couplés auxdits moyens (86) de génération de signaux de synchronisation et auxdits moyens (88, 90, 92, 94) de commande et disposés à proximité immédiate dudit premier bord (78), et en ce que des moyens (110) à bus de mode sont prévus, couplés auxdits moyens à registre (70) et auxdits moyens de commande (88, 90, 92, 94) et s'étendant sensiblement à travers le milieu dudit circuit intégré, parallèlement auxdits premier et troisième bords (78, 80).

2. Circuit intégré selon la revendication 2, caractérisé par plusieurs plot de connexion disposés à proximité dudit troisième bord (80), lesdits plots de connexion étant couplés auxdits moyens de mémorisation de sortie (30, 100, 40; 30, 104, 40).

3. Circuit intégré selon la revendication 3, caractérisé en ce que lesdits moyens (86) de génération de signaux de synchronisation comprennent un compteur (114) couplé à un décoder (116) qui est couplé à un sélecteur de fréquence (118) conçu pour produire celui, souhaité, desdits premier et second signaux de synchronisation conformément aux signaux de commande mémorisés dans lesdits moyen à registre (70).

4. Circuit intégré selon la revendication 4, caractérisé en ce que lesdits moyens de commande comprennent un circuit (148) de commande d'émission qui, en réponse à un signal de commande d'émission produit par ledit processeur, permet à un circuit génerateur d'horloge (150) de produire des signaux d'horloge de sortie à appliquer auxdits dispositifs éloignés, permettant ainsi aux bits de données mémorisés dans lesdits moyens de mémorisation de sortie (30, 100, 40) d'être transmis à un dispositif éloigné.

5. Circuit intégré selon la revendication 5, caractérisé en ce que lesdits moyens à registre (70) sont conçus pour mémoriser un autre signal de commande reçu dudit processeur pour sélectionner le nombre de bits de données à transmettre auxdits dispositifs éloignés, lesdits moyens de commande comprenant un autre compteur (154) couplé audit circuit génerateur d'horloge (150) et à un circuit (156) à compteur-décodeur couplé auxdits moyens à registre (70) et conçu pour limiter le nombre desdits signaux d'horloge de sortie conformément audit autre signal de commande.

6. Circuit intégré selon la revendication 6, caractérisé par un dispositif décodeur (96) conçu pour être couplé audit processeur et pour produire ledit signal de commande et ledit autre signal de commande et pour commander l'adressage desdits dispositifs éloignés, ledit dispositif décodeur (96) étant disposé à proximité de l'angle entre lesdits premier (78) et quatrième (76) bords.

6. Circuit intégré selon la revendication 7, caractérise en ce que chaque partie de mémorisation de sortie comprennent un tampon de sortie (30) conçu pour recevoir un caractère de donne produit en parallèle par ledit processeur et un registre à décalage sériel (40) couplé audit tampon de sortie (30) et conçu pour recevoir en parallèle ledit caractère de donnée provenant dudit tampon de sortie (30) et pour faire sortie par décalage le caractère de donnée pour transmission à un dispositif éloigné en synchronisme avec lesdits signaux d'horloge.

8. Circuit intégré selon la revendication 1, caractérisé par des moyens de mémorisation d'entrée (50, 98, 54; 50, 102, 54) conçus pour mémoriser des données reçues d'un dispositif éloigné, lesdits moyens de mémorisation d'entrée (50, 98, 54; 50, 102, 54) étant disposés sensiblement plus près dudit troisième bord (80) que dudit premier bord (78), et comprenant des première et seconde parties de mémorisation d'entrée (50, 98, 54; 50, 102, 54) couplées auxdits moyens à bus d'adresse (106).

FIG. 1A

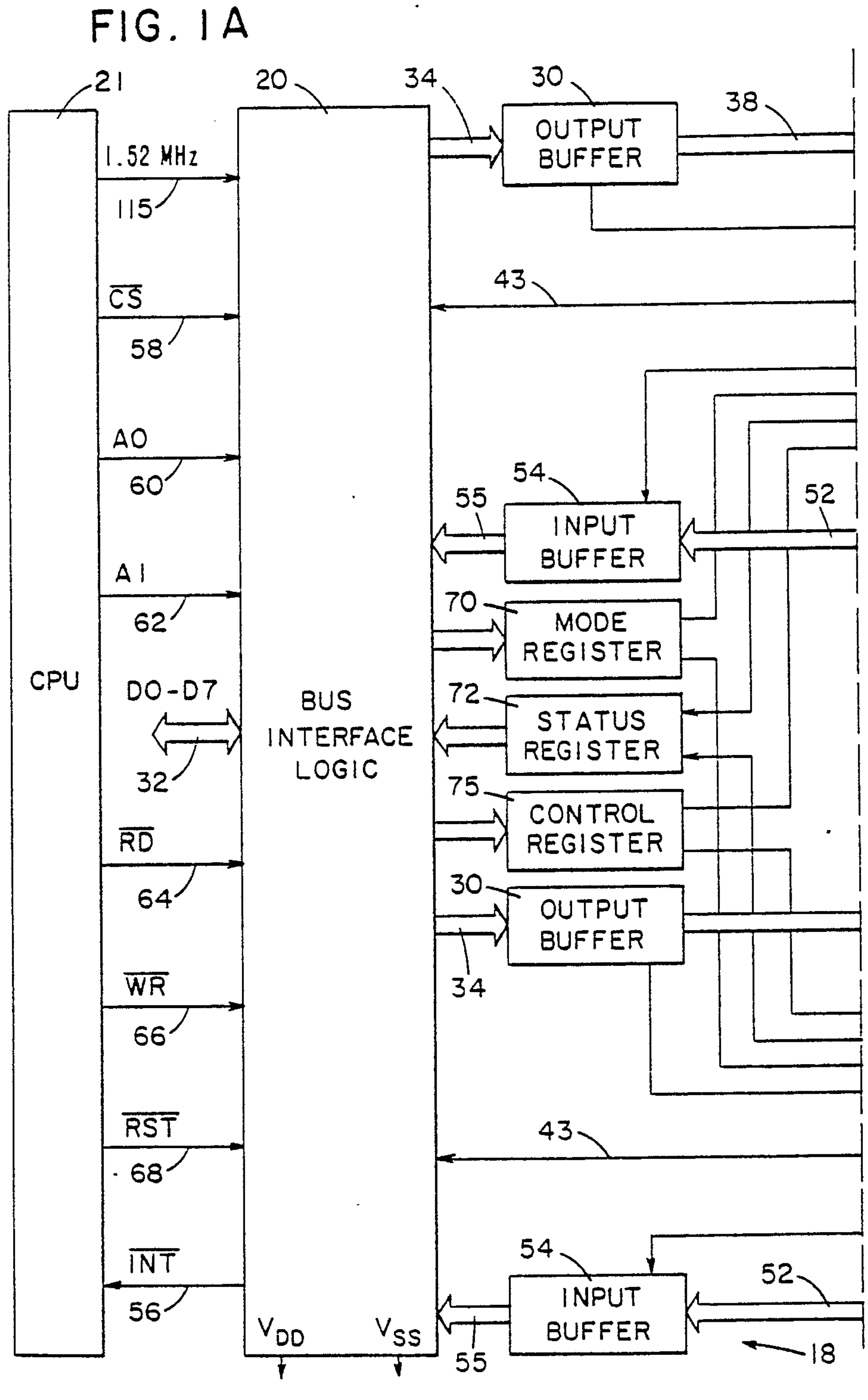
CPU
21
20
BUS INTERFACE LOGIC
1.52 MHz
115
CS
58
AO
60
A1
62
DO-D7
32
RD
64
WR
66
RST
68
INT
56
VDD
VSS
34
30
OUTPUT BUFFER
38
43
54
55
INPUT BUFFER
52
70
MODE REGISTER
72
STATUS REGISTER
75
CONTROL REGISTER
18

FIG. 1B

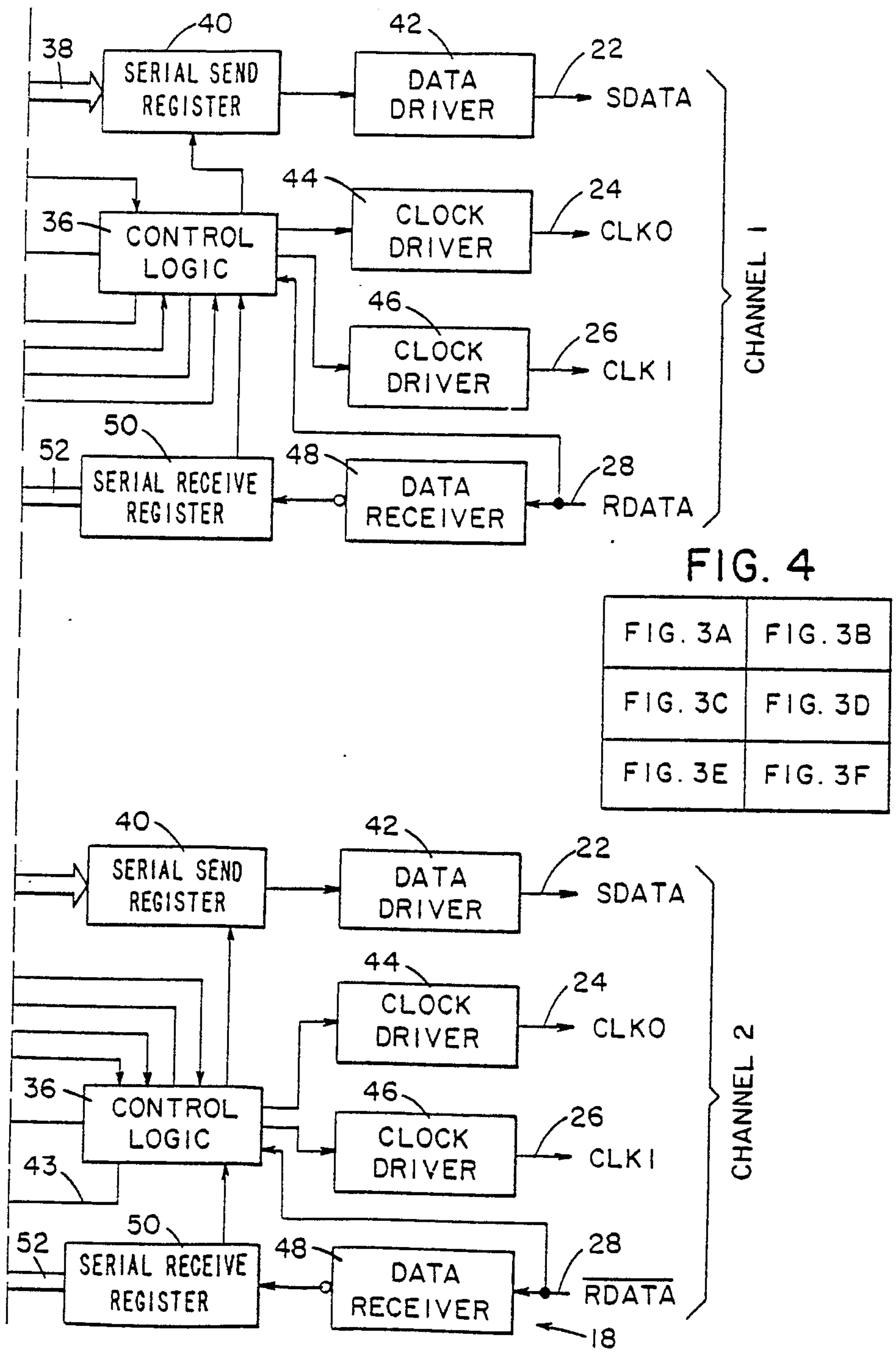


FIG. 4

| | |
|---|---|
| FIG. 3A | FIG. 3B |
| FIG. 3C | FIG. 3D |
| FIG. 3E | FIG. 3F |

FIG. 2

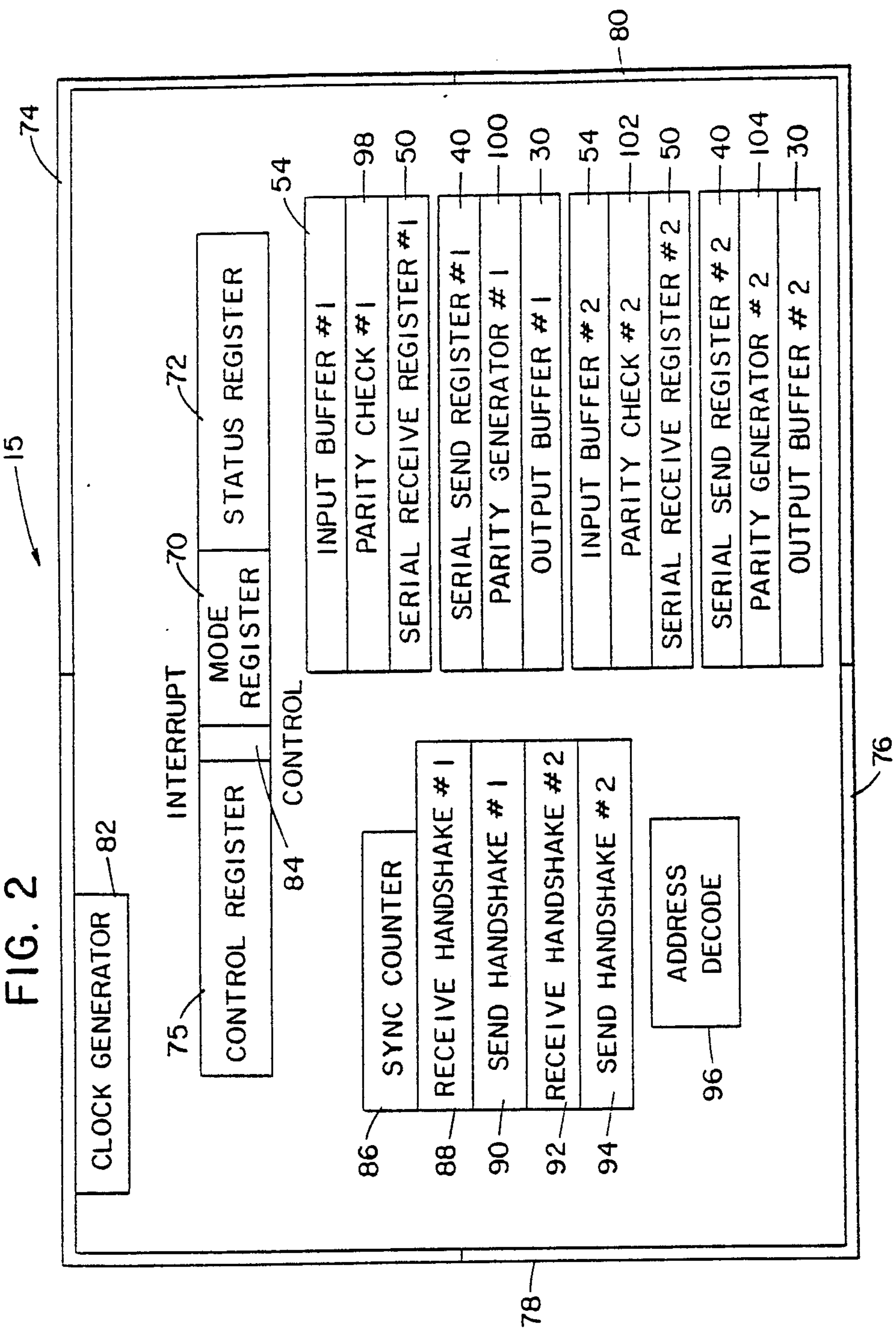

15
74
80
76
78
CLOCK GENERATOR
82
CONTROL REGISTER
75
INTERRUPT
MODE REGISTER
70
STATUS REGISTER
72
CONTROL
84
SYNC COUNTER
86
RECEIVE HANDSHAKE #1
88
SEND HANDSHAKE #1
90
RECEIVE HANDSHAKE #2
92
SEND HANDSHAKE #2
94
ADDRESS DECODE
96
INPUT BUFFER #1
54
PARITY CHECK #1
98
SERIAL RECEIVE REGISTER #1
50
SERIAL SEND REGISTER #1
40
PARITY GENERATOR #1
100
OUTPUT BUFFER #1
30
INPUT BUFFER #2
54
PARITY CHECK #2
102
SERIAL RECEIVE REGISTER #2
50
SERIAL SEND REGISTER #2
40
PARITY GENERATOR #2
104
OUTPUT BUFFER #2
30

FIG. 3A

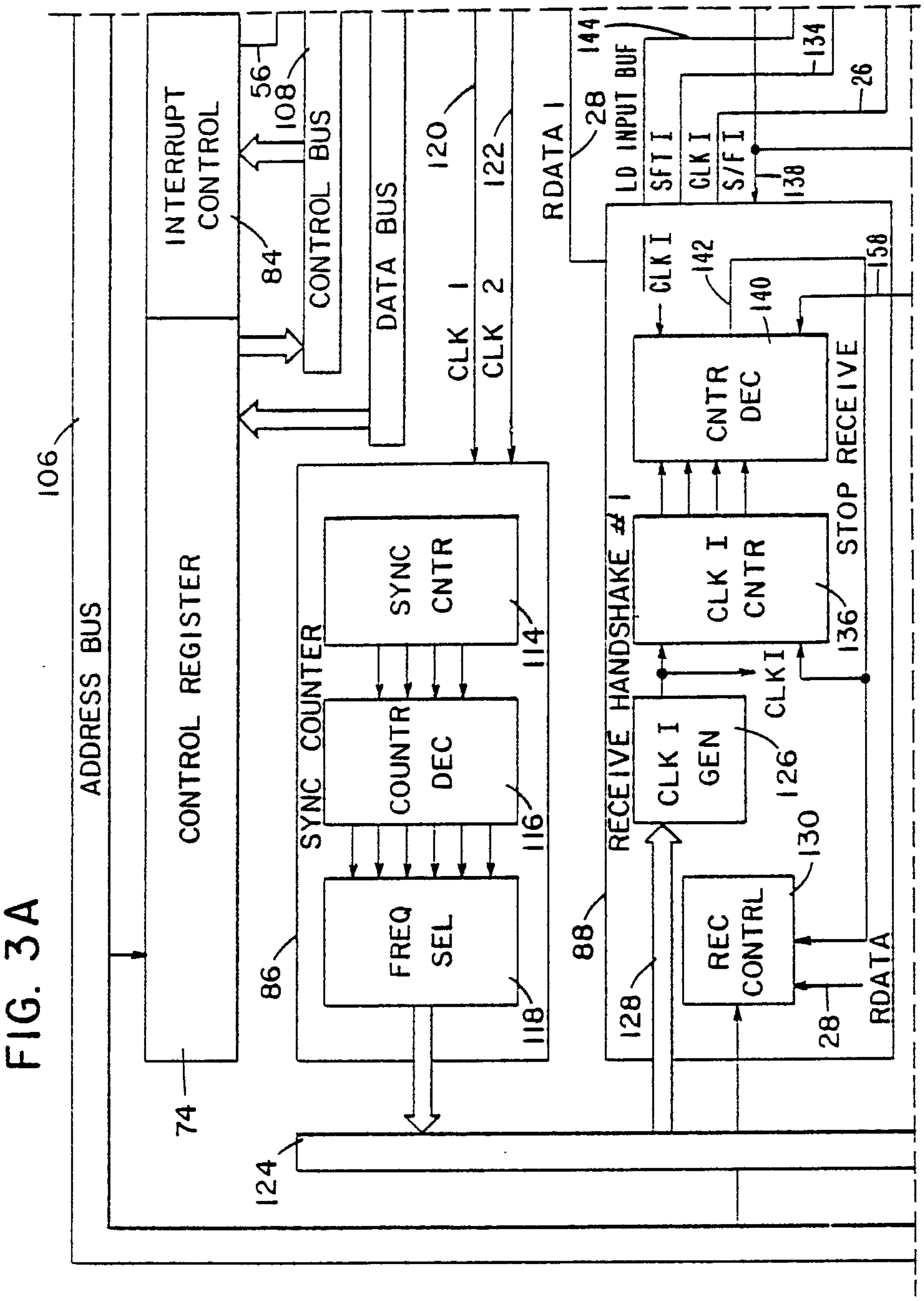
ADDRESS BUS
106
CONTROL REGISTER
74
INTERRUPT CONTROL
84
56
108
CONTROL BUS
DATA BUS
120
122
CLK 1
CLK 2
SYNC COUNTER
86
SYNC CNTR
114
COUNTR DEC
116
FREQ SEL
118
124
RDATA I
28
LD INPUT BUF
SFT I
CLK I
S/F I
144
134
26
138
RECEIVE HANDSHAKE # 1
88
CLK I
142
140
158
CNTR DEC
CLK I CNTR
136
STOP RECEIVE
CLK I GEN
126
CLK I
128
REC CONTRL
130
RDATA
28

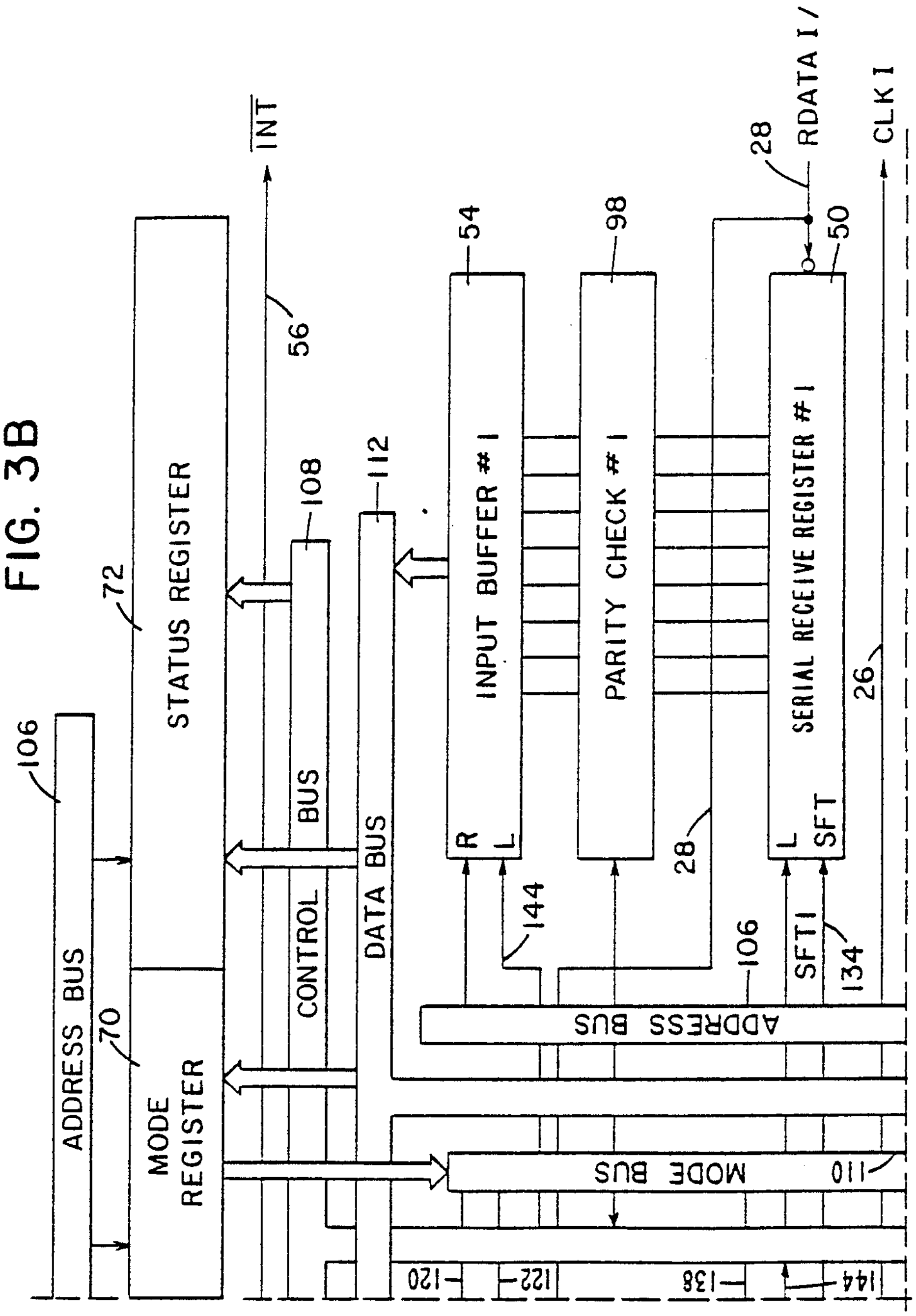
ADDRESS BUS
106
MODE REGISTER
70
STATUS REGISTER
72
INT
56
CONTROL BUS
108
DATA BUS
112
INPUT BUFFER #1
54
R
L
144
PARITY CHECK #1
98
SERIAL RECEIVE REGISTER #1
50
L
SFT
28
RDATA I /
CLK I
26
SFTI
134
106
ADDRESS BUS
MODE BUS
110
120
122
138
144

FIG. 3B

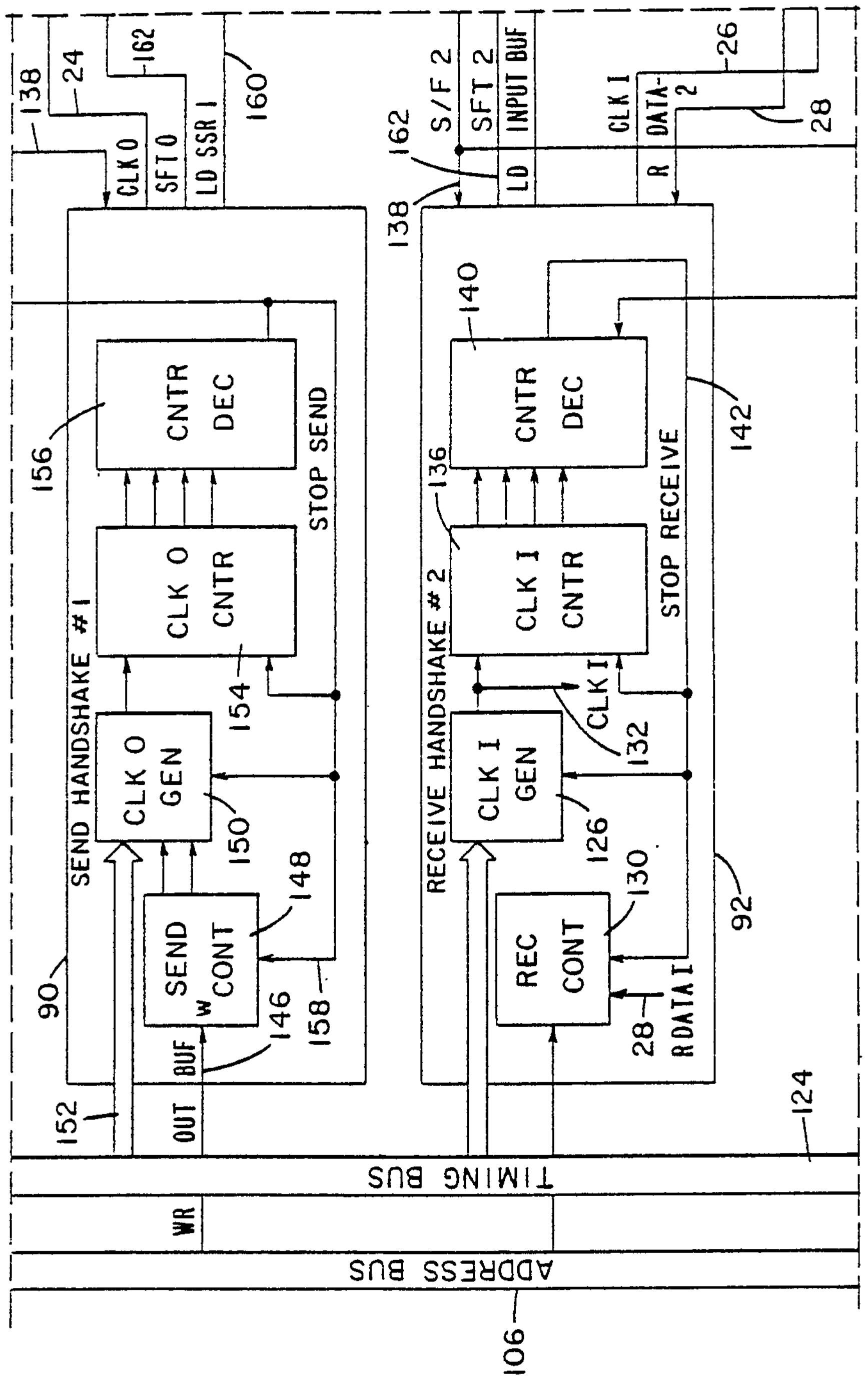
CLK O
SFT O
LD SSR I
S/F 2
SFT 2
INPUT BUF
LD
CLK I
DATA-2
R
CNTR DEC
CLK O CNTR
CLK O GEN
SEND CONT
SEND HANDSHAKE #1
STOP SEND
OUT BUF
CNTR DEC
CLK I CNTR
CLK I GEN
REC CONT
RECEIVE HANDSHAKE #2
STOP RECEIVE
CLK I
R DATA I
TIMING BUS
WR
ADDRESS BUS
138
24
162
160
26
28
156
154
150
148
146
158
152
90
140
142
136
132
126
130
92
124
106

FIG. 3C

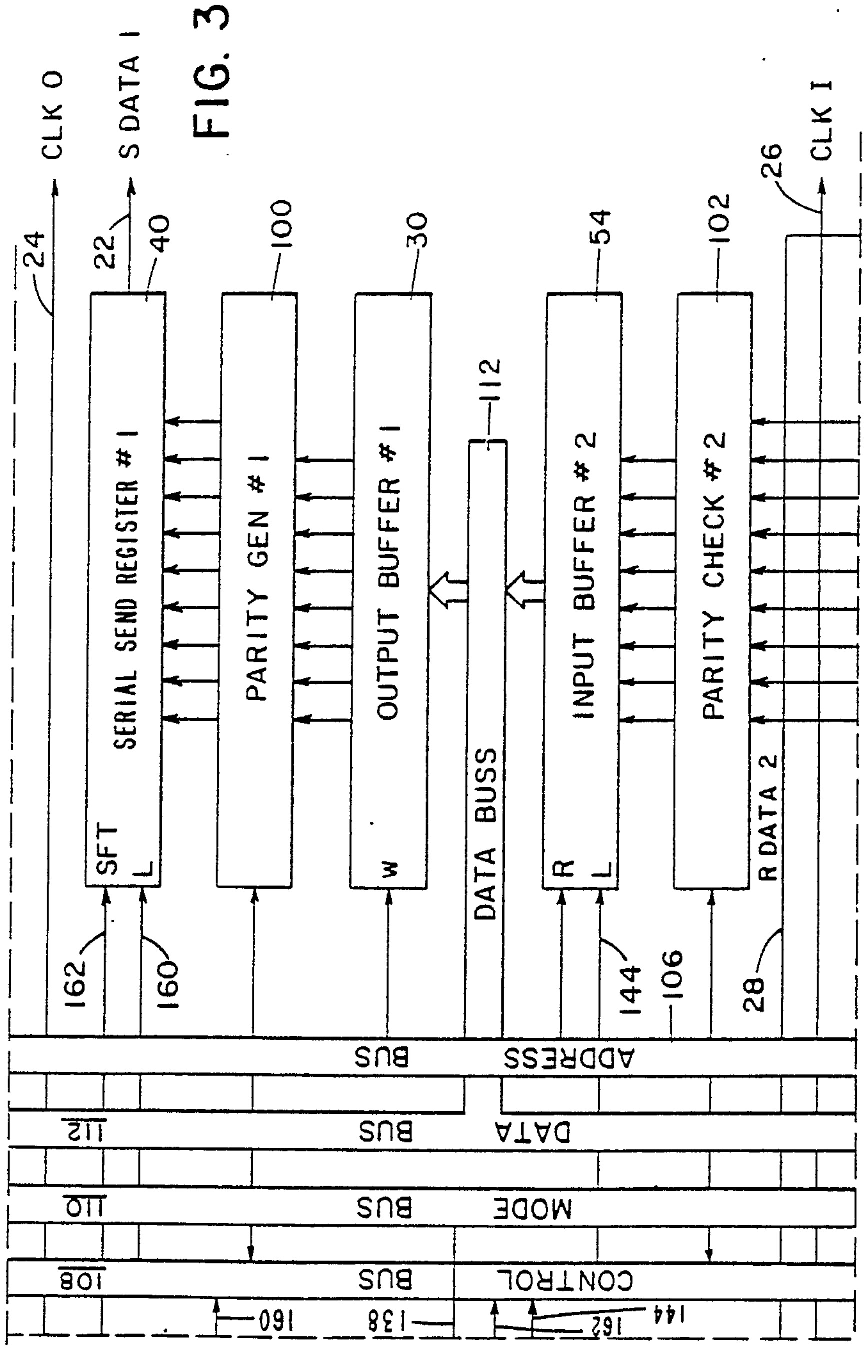
CLK O
S DATA I
SERIAL SEND REGISTER # I
PARITY GEN # I
OUTPUT BUFFER # I
DATA BUSS
INPUT BUFFER # 2
PARITY CHECK # 2
R DATA 2
CLK I
SFT
L
W
R
L
24
22
40
100
30
112
54
102
26
162
160
144
106
28
ADDRESS BUS
DATA BUS
112
MODE BUS
110
CONTROL BUS
108
160
138
162
144

FIG. 3D

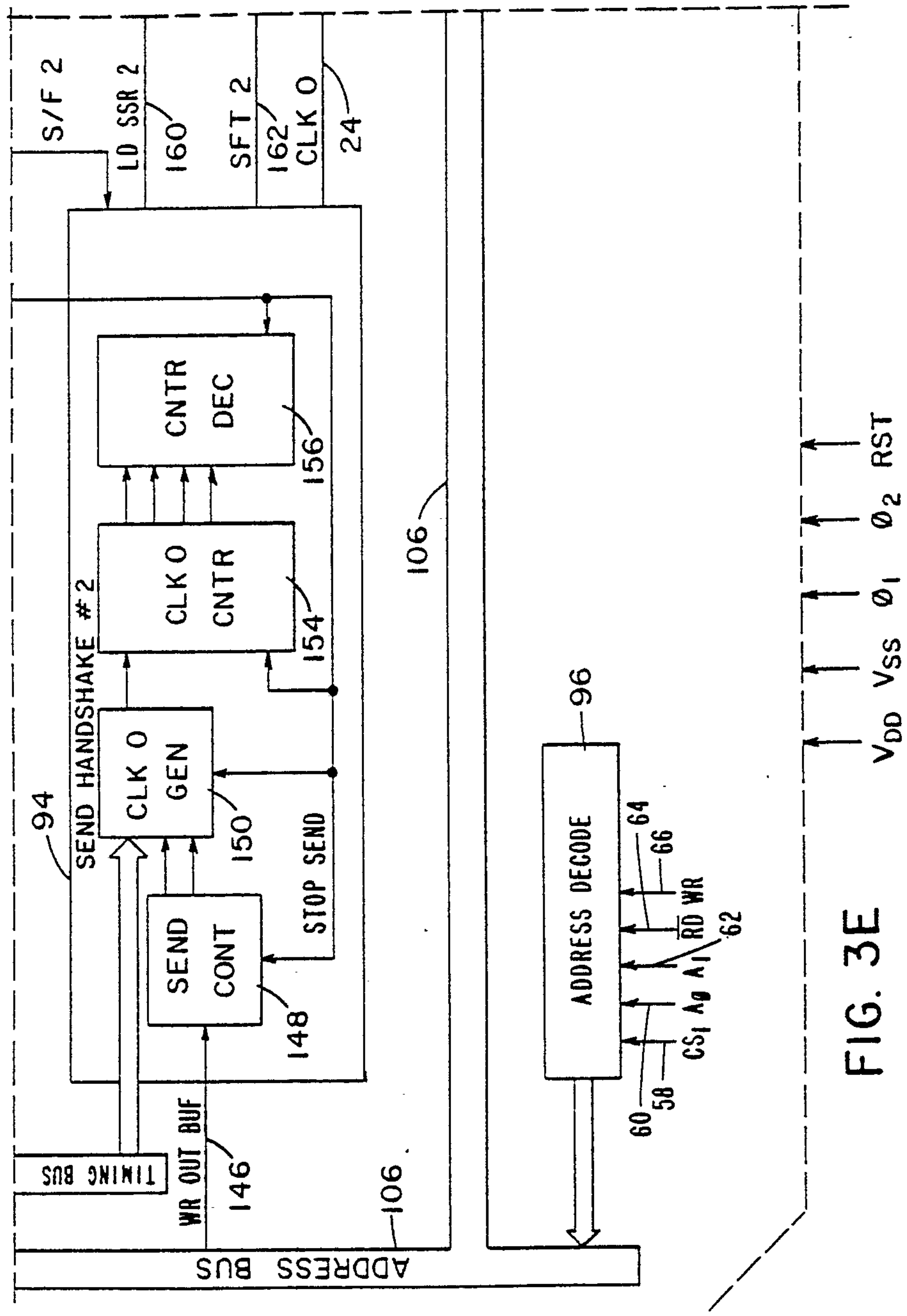
S/F 2
LD SSR 2
160
SFT 2
162
CLK O
24
SEND HANDSHAKE #2
94
CNTR DEC
156
CLK O CNTR
154
CLK O GEN
150
SEND CONT
148
STOP SEND
TIMING BUS
WR OUT BUF
146
106
ADDRESS BUS
96
ADDRESS DECODE
64
66
RD WR
62
$CS_1$ $A_0$ $A_1$
60
58
$V_{DD}$ $V_{SS}$ $Ø_1$ $Ø_2$ RST

FIG. 3E

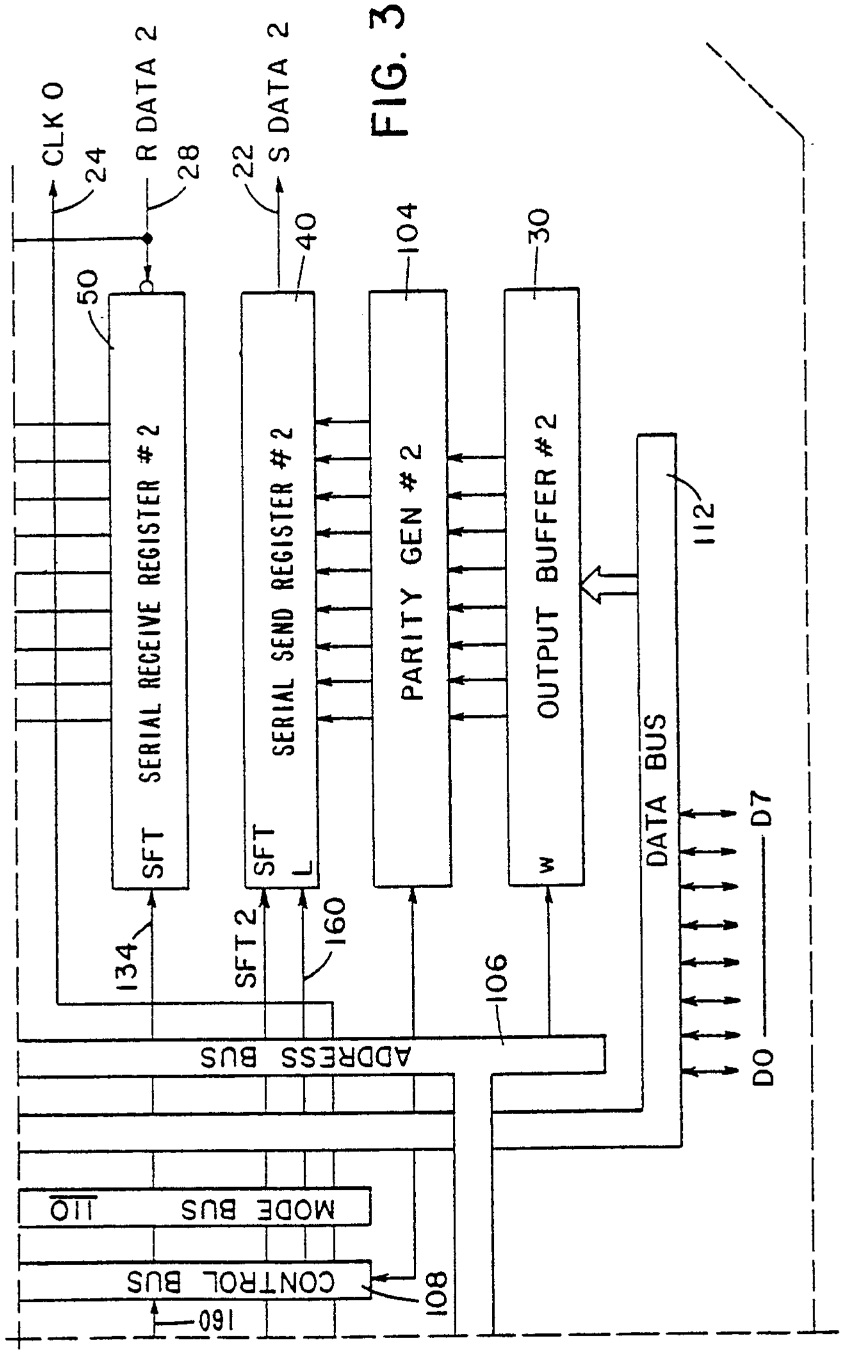
CLK 0
24
R DATA 2
28
22
S DATA 2
40
104
30
50
SERIAL RECEIVE REGISTER #2
SERIAL SEND REGISTER #2
PARITY GEN #2
OUTPUT BUFFER #2
SFT
SFT
L
W
112
DATA BUS
D7
D0
134
SFT 2
160
106
ADDRESS BUS
MODE BUS
110
CONTROL BUS
160
108

FIG. 3F

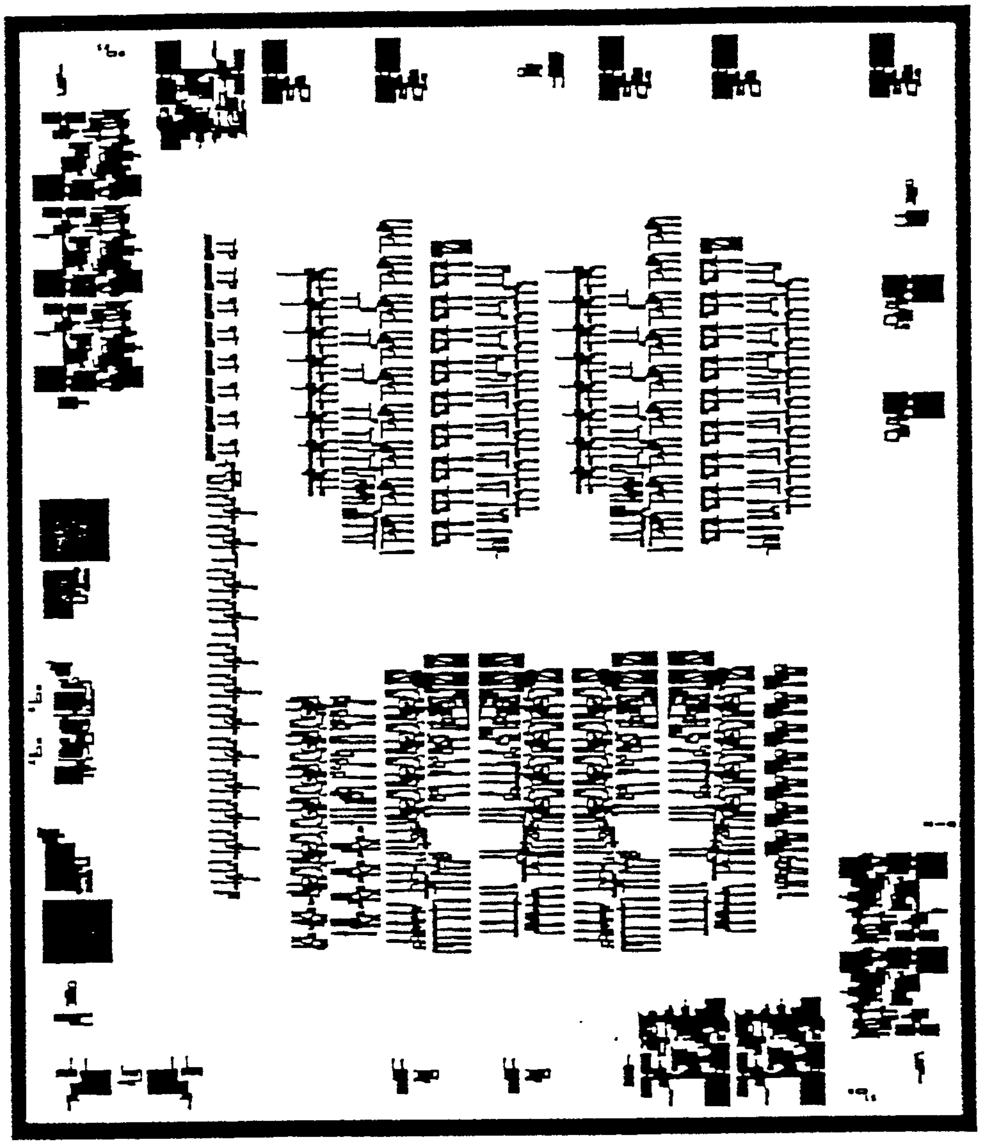

FIG. 5

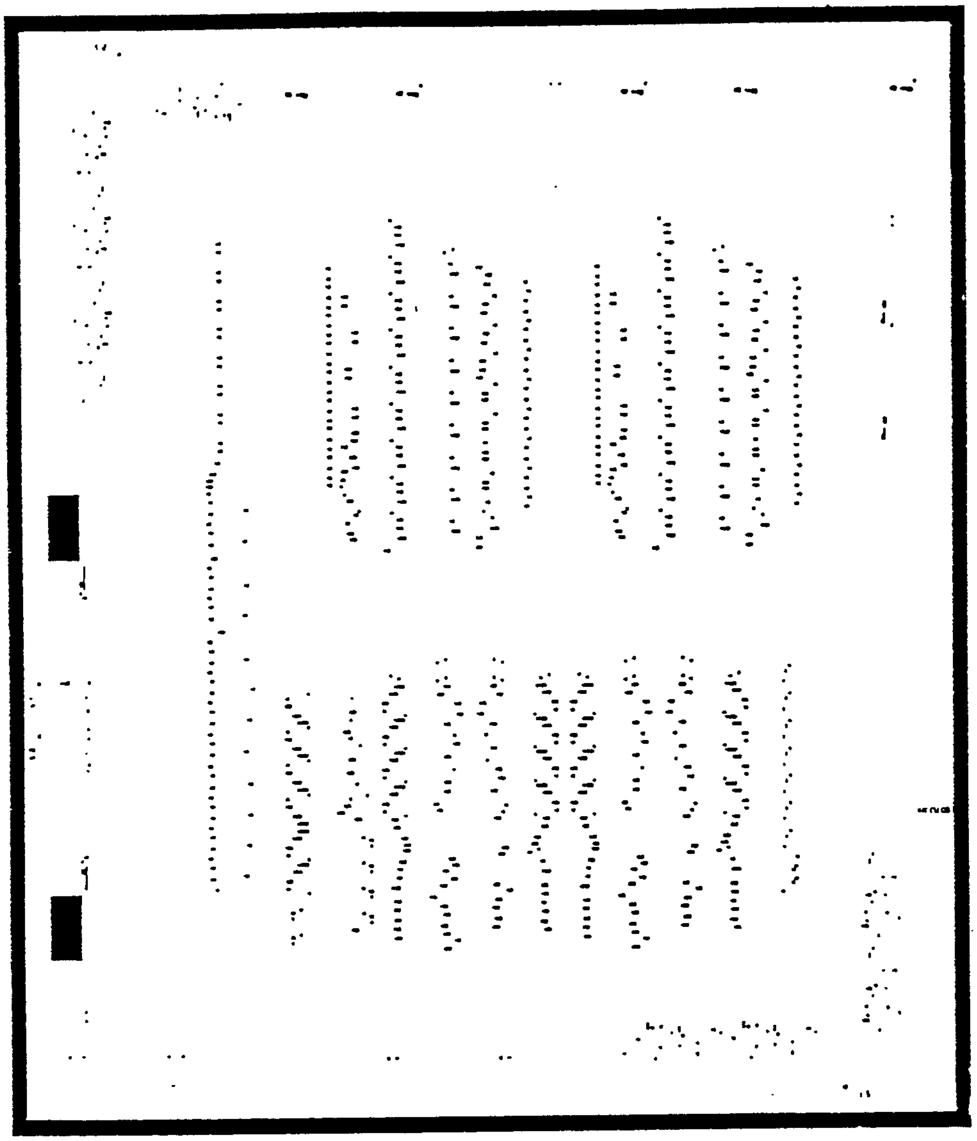

FIG. 6

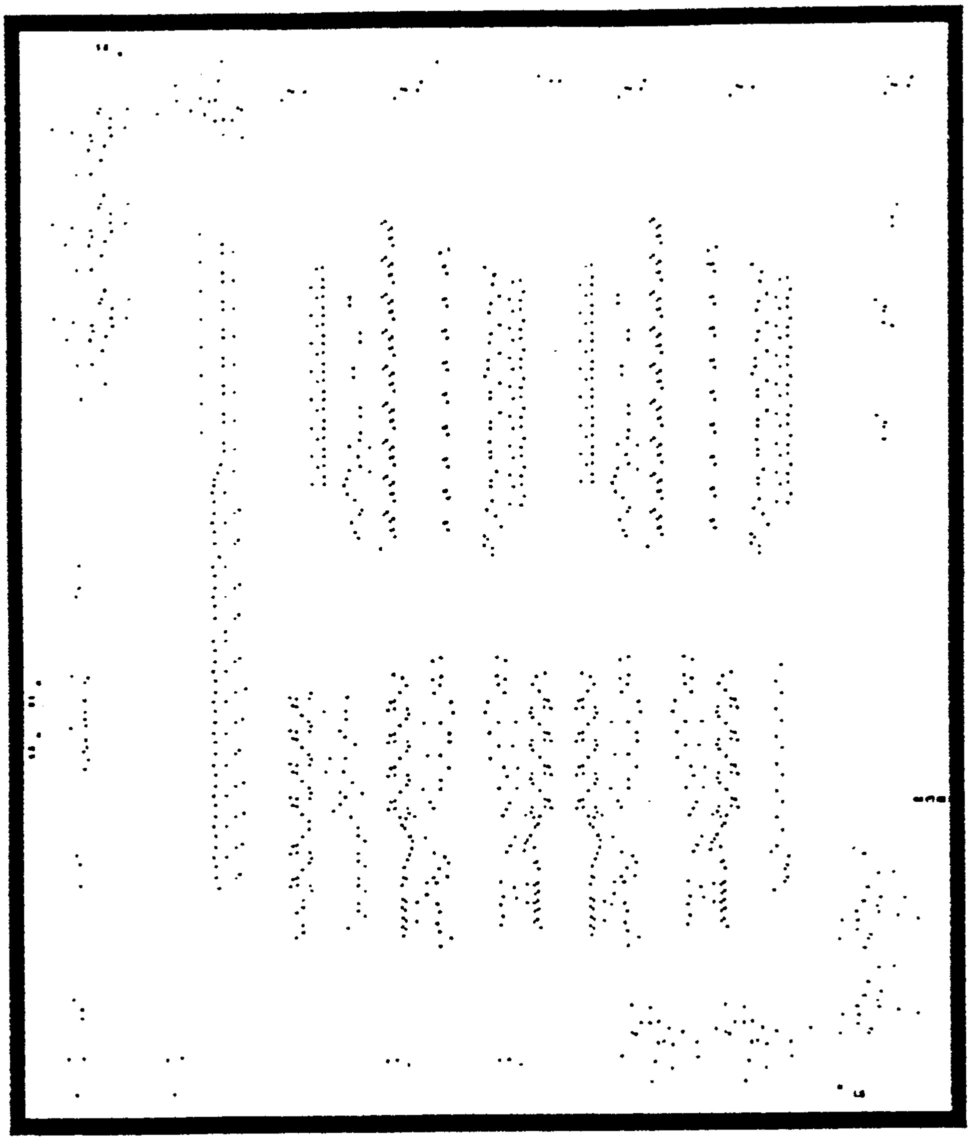

FIG. 7

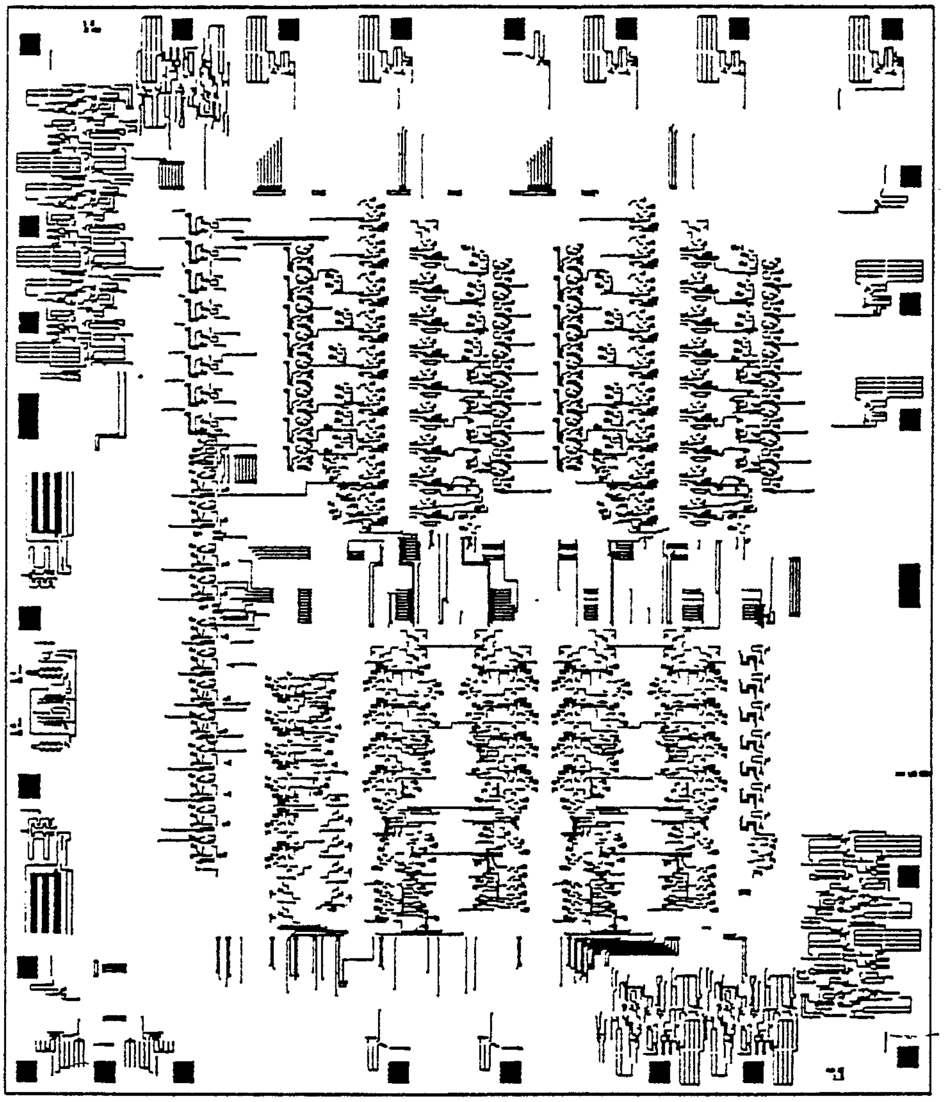

FIG. 8

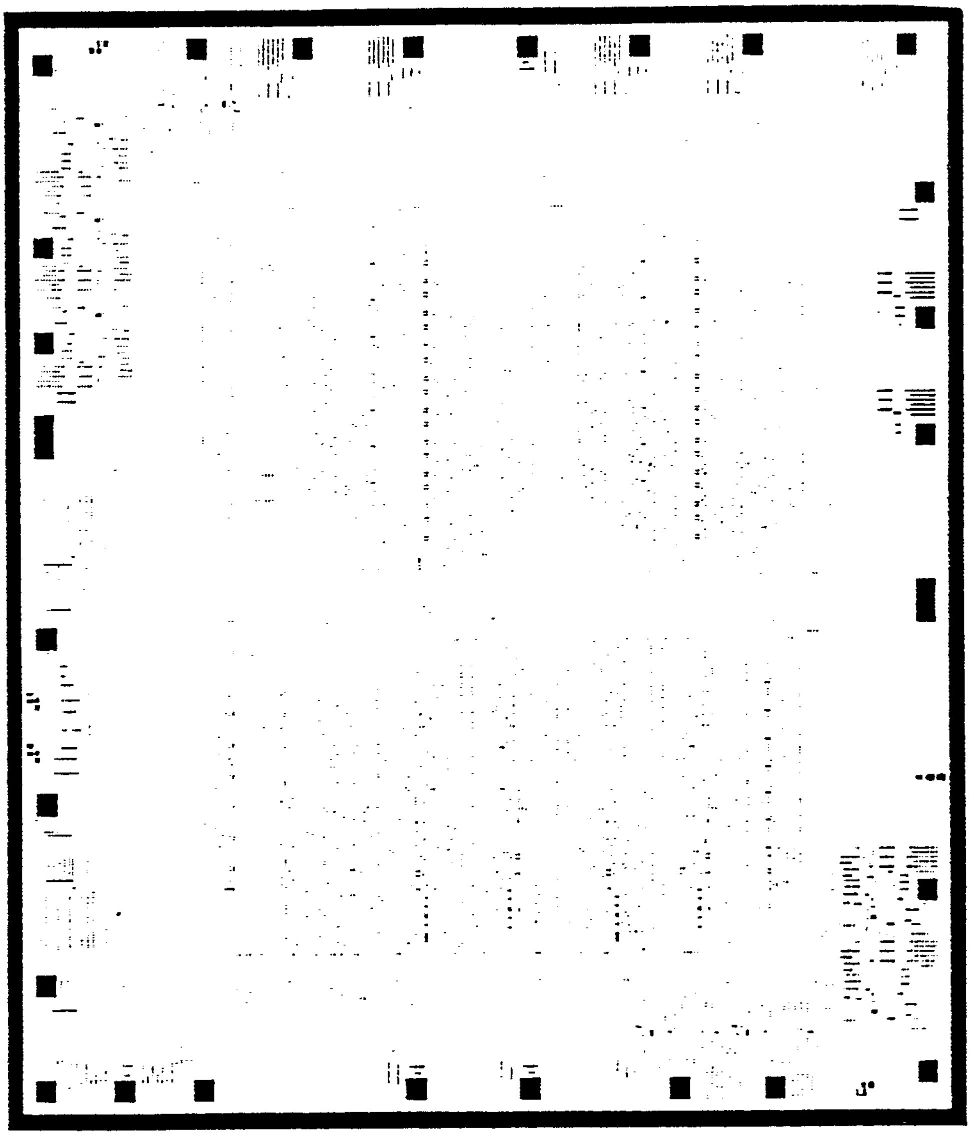

FIG. 9

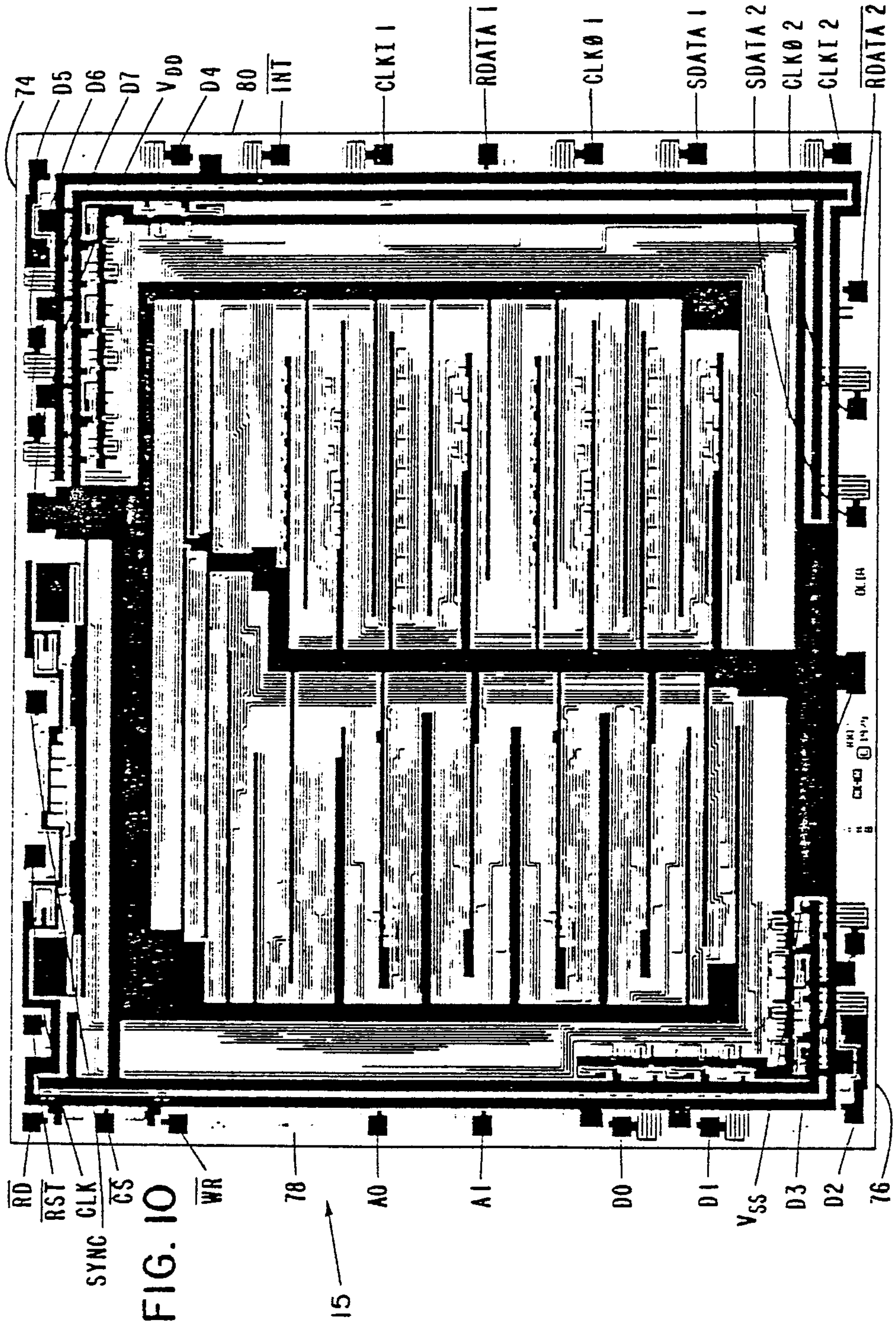
74
D5
D6
D7
$V_{DD}$
D4
80
INT
CLKI 1
RDATA 1
CLKØ 1
SDATA 1
SDATA 2
CLKØ 2
CLKI 2
RDATA 2
RD
RST
CLK
SYNC
CS
WR
78
A0
A1
D0
D1
$V_{SS}$
D3
D2
76
15

FIG. 10

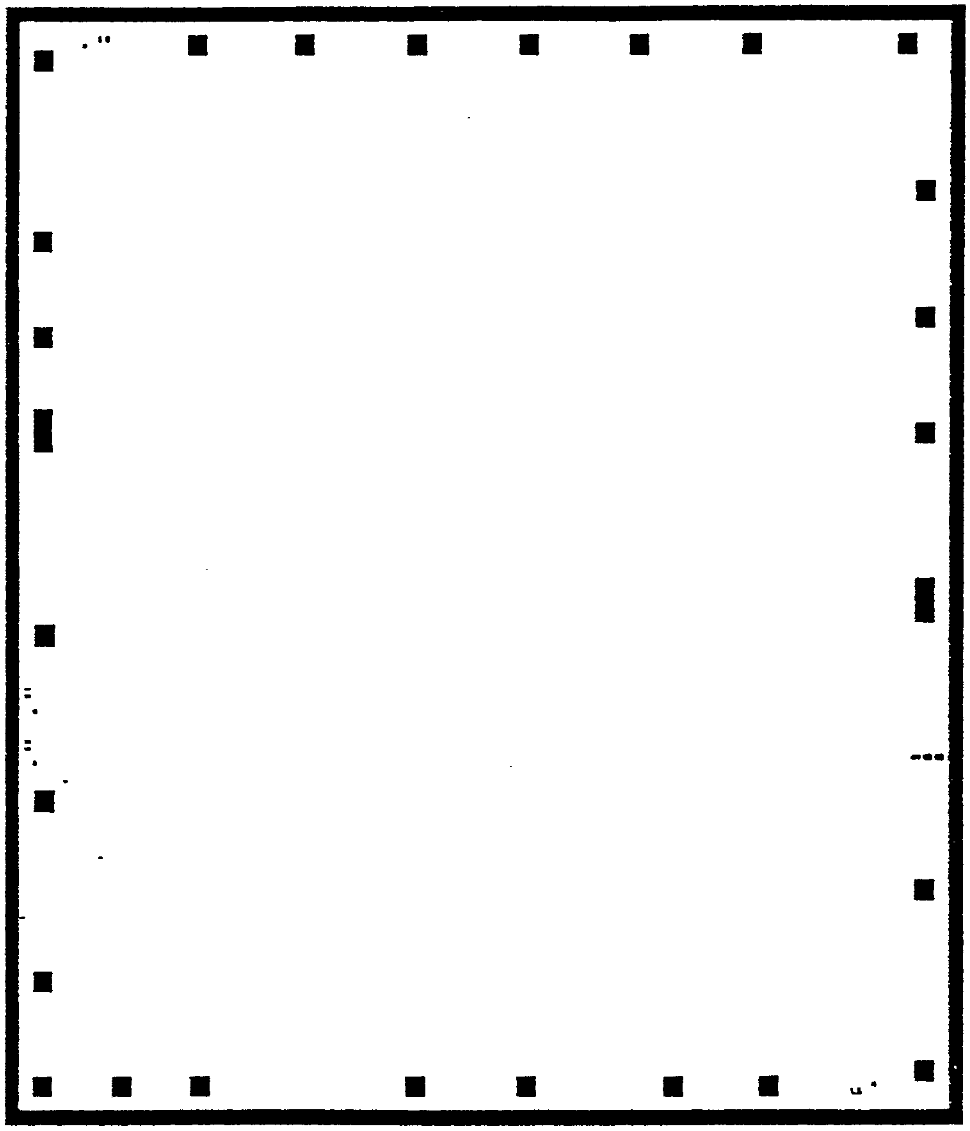

FIG. 11

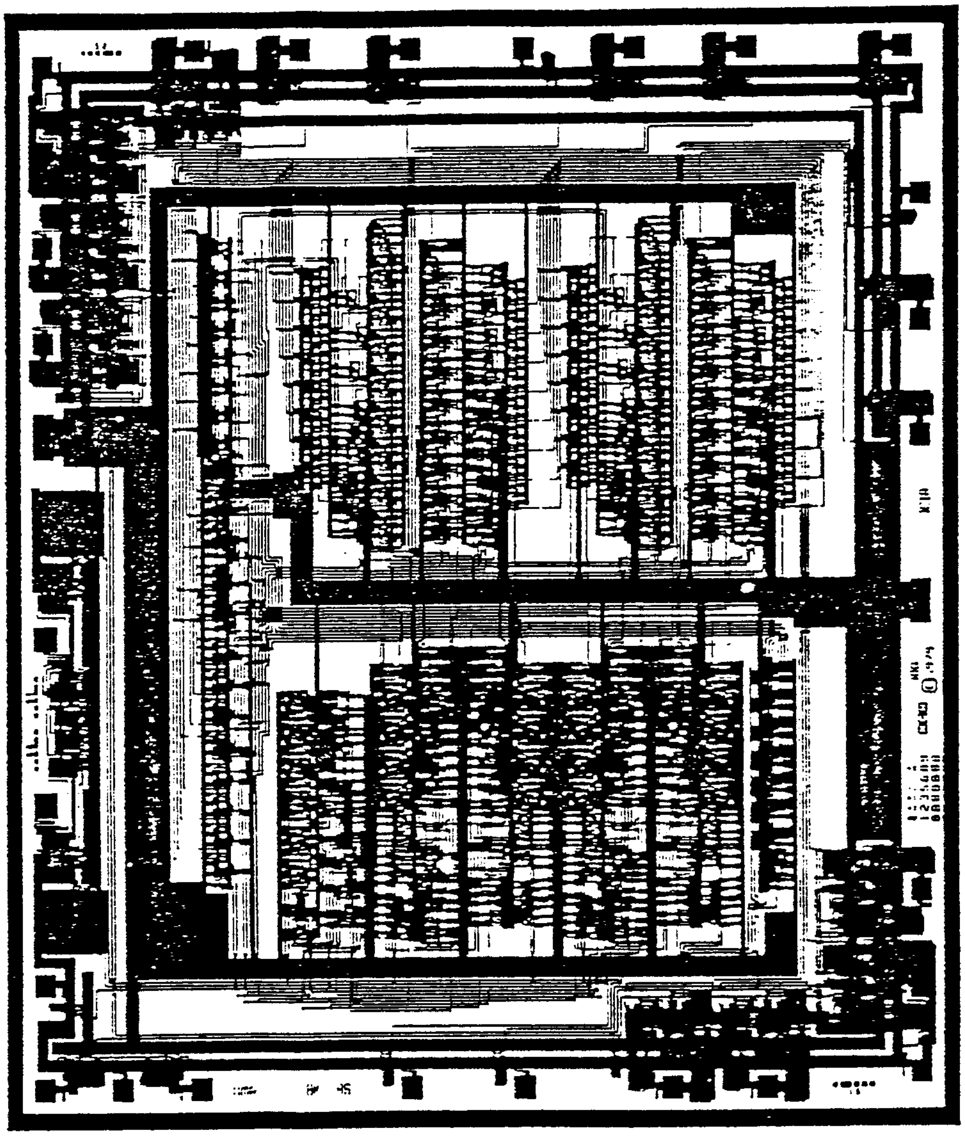

FIG. 12

FIG. 13

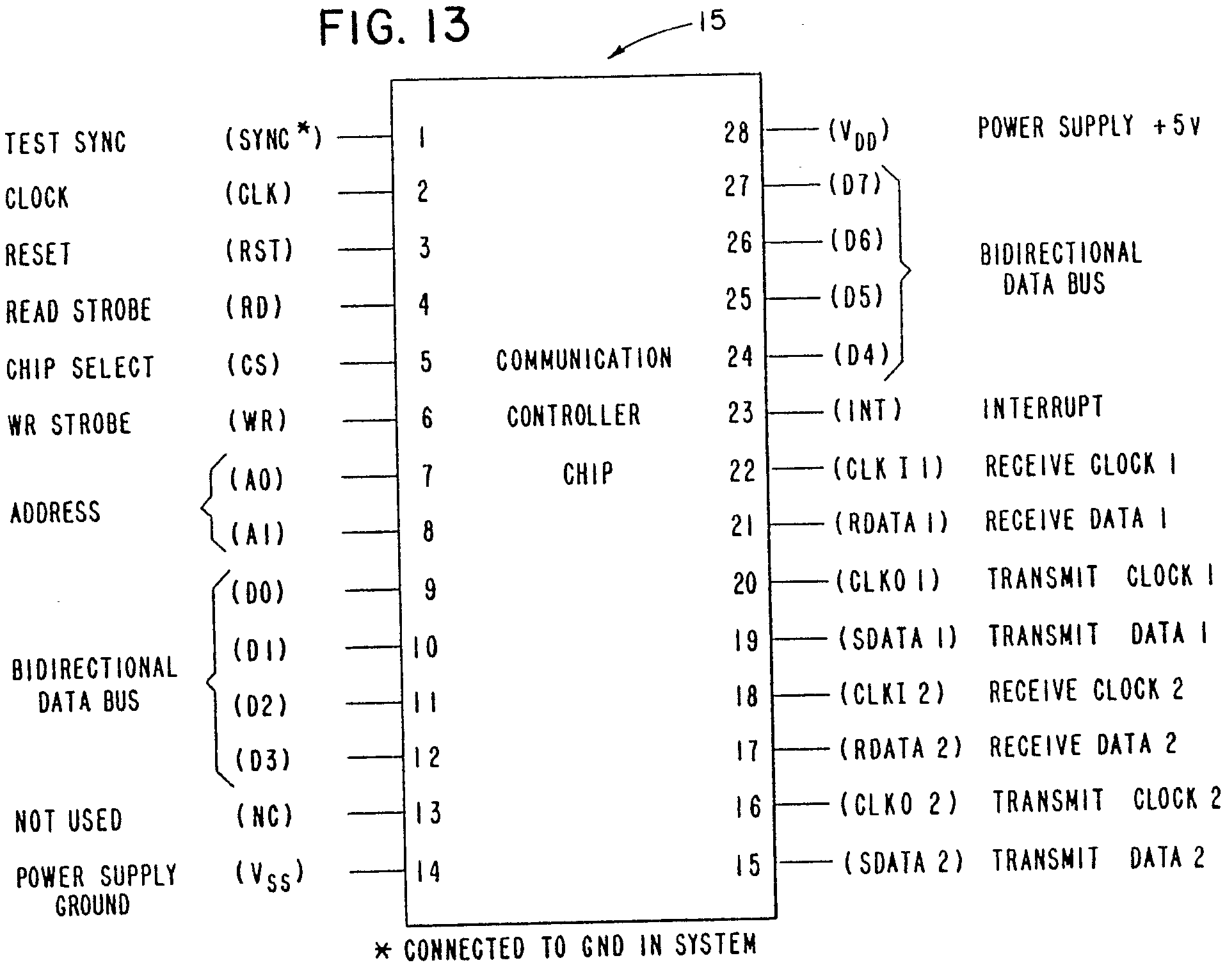
15
TEST SYNC (SYNC*) 1
CLOCK (CLK) 2
RESET (RST) 3
READ STROBE (RD) 4
CHIP SELECT (CS) 5
WR STROBE (WR) 6
ADDRESS (A0) 7 (A1) 8
BIDIRECTIONAL DATA BUS (D0) 9 (D1) 10 (D2) 11 (D3) 12
NOT USED (NC) 13
POWER SUPPLY GROUND (V_SS) 14
COMMUNICATION CONTROLLER CHIP
28 (V_DD) POWER SUPPLY +5V
27 (D7) 26 (D6) 25 (D5) 24 (D4) BIDIRECTIONAL DATA BUS
23 (INT) INTERRUPT
22 (CLK I 1) RECEIVE CLOCK 1
21 (RDATA 1) RECEIVE DATA 1
20 (CLKO 1) TRANSMIT CLOCK 1
19 (SDATA 1) TRANSMIT DATA 1
18 (CLKI 2) RECEIVE CLOCK 2
17 (RDATA 2) RECEIVE DATA 2
16 (CLKO 2) TRANSMIT CLOCK 2
15 (SDATA 2) TRANSMIT DATA 2
* CONNECTED TO GND IN SYSTEM